(19)

**Europäisches Patentamt**
**European Patent Office**
**Office européen des brevets**

(11) **EP 4 766 107 A1**

(12) **EUROPEAN PATENT APPLICATION**

(43) Date of publication:
24.06.2026 Bulletin 2026/26

(21) Application number: 25208931.3

(22) Date of filing: 15.10.2025

(51) International Patent Classification (IPC):
*H10H 29/03* (2025.01)    *H10H 29/34* (2025.01)

(52) Cooperative Patent Classification (CPC):
H10H 29/03; H10H 29/34

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  23.12.2024  KR 20240194284

(71) Applicant: **LG Display Co., Ltd.**
**Seoul, 07336 (KR)**

(72) Inventors:
• **AN, Chung Hwan**
  **10845 Gyeonggi-do (KR)**
• **SON, Hyeon Ho**
  **10485 Gyeonggi-do (KR)**
• **PARK, Hyung Ju**
  **10845 Gyeonggi-do (KR)**
• **KIM, Do Jin**
  **10845 Gyeonggi-do (KR)**
• **JAE, Jong Ha**
  **10845 Gyeonggi-do (KR)**
• **LEE, Tae Sung**
  **10845 Gyeonggi-do (KR)**

(74) Representative: **Ter Meer Steinmeister & Partner
Patentanwälte mbB
Nymphenburger Straße 4
80335 München (DE)**

(54) **DISPLAY PANEL AND METHOD OF MANUFACTURING THE SAME**

(57)    A display panel includes a substrate with a plurality of pixels, each pixel having a first pattern area and a second pattern area adjacent to the first pattern area. An insulating layer is disposed on the substrate and includes a first intaglio pattern in the first pattern area. A pair of light-emitting elements is disposed on the first intaglio pattern of the insulating layer. The first intaglio pattern has a length in a first direction and a length in a second direction different from the first direction. Light-emitting areas of the pair of light-emitting elements are offset in different directions from an extension line in the first direction or the second direction extending from a center of the first intaglio pattern, enabling improved display quality even when one light emitting element is defective.

FIG. 3

IP1 : IP1-1, IP1-2, IP1-3

**(Cont. next page)**

FIG. 4

## Description

This application claims priority of Korean Patent Application No. 10-2024-0194284, filed on December 23, 2024.

## BACKGROUND

### Technical Field

The application relates to a display panel and a method of manufacturing the same, and more particularly, to a display panel and a method of manufacturing the same that may improve the productivity of a pair of light-emitting elements (e.g., micro light-emitting diodes (micro LEDs)) disposed in different directions and prevent stains caused by defective light-emitting elements from being visible.

### Description of Related Art

With the advent of a full-scale information age, the field of display devices for visually displaying electrical information signals is rapidly advancing. Accordingly, research is being conducted to improve some aspects including thinning, weight reduction, and low power consumption for various display devices.

Specific examples of the display devices may include liquid crystal display (LCD) devices, light-emitting display (LED) devices, quantum dot display devices, and the like.

Among these display devices, the LED devices may include an organic light-emitting diode (OLED) display device, which includes an organic material as a light-emitting layer, or a micro light-emitting diode (micro LED) display device, which includes an inorganic material as a light-emitting layer.

Here, the micro LED display device uses an inorganic material, which is resistant to moisture and oxygen, as its light-emitting layer and thus is less affected by external environmental factors, thereby ensuring high reliability and providing a longer lifespan compared to the OLED display device. In addition, the micro LED display device has the advantage of implementing a flexible display device while having a thinner structure than the OLED display device.

Micro LED transfer technology is a process of transferring micro LED chips (light-emitting element chips) grown on a growth substrate onto a panel substrate. As micro LED chips become increasingly smaller, research is being conducted on technologies for transferring the micro LED chips onto a panel substrate with high precision.

## BRIEF SUMMARY

A display panel including micro light-emitting diodes (micro LEDs) may include one or more sub-pixel units in each pixel. The one or more sub-pixel units may include a first light-emitting element (a first sub-pixel) and a second light-emitting element (a second sub-pixel) to prepare for defective chips in the process of properly transferring the respective light-emitting element onto a substrate of the panel.

Here, when one defective light-emitting element occurs in each sub-pixel unit, a stain may become visible due to a distance difference between the first light-emitting element and the second light-emitting element.

Further, depending on the uniformity of an adhesive layer, issues such as non-transfer defects, in which light-emitting elements fail to be transferred onto the panel, or over-transfer defects, in which light-emitting elements are excessively transferred onto the panel, may occur.

It is an object to improving the productivity of a pair of light-emitting elements (for example, micro LEDs) disposed in different directions while preventing stains caused by defective light-emitting elements from becoming visible.

The problems to be solved in the application are not limited to the above-mentioned technical problems, and other unmentioned technical problems can be clearly understood by those skilled in the art to which the technical ideas of the application belong from the description below.

The disclosed display panel architecture uses sub-pixels that each include a pair of light emitting elements, one main element and one redundancy element, arranged within precisely formed intaglio patterns on the substrate. This configuration ensures that even if one element is defective, the other maintains display quality, preventing visible defects such as stains or dead pixels. By arranging the light emitting areas to face each other and controlling their spacing to be smaller than the human eye's binocular resolution, the design minimizes color shift and ensures that defects remain imperceptible to viewers.

The manufacturing method employs a twice stamping transfer process using two types of intaglio patterns. The first intaglio pattern provides the final placement of the elements while the second intaglio pattern serves as a temporary seating area during transfer. This multi stage process improves placement accuracy, reduces cluster defects, and allows for much tighter spacing between light emitting elements compared to conventional single step transfer methods. The method also includes an optimized adhesive layer etching process to improve electrode contact and uniformity across the panel.

The design further incorporates shared pixel driving circuits for multiple sub-pixels, simplifying the overall panel structure and reducing power consumption while supporting high resolution micro LED displays. These features alone or in combination enhance manufacturing yield, productivity, and display performance, making the technology suitable for advanced high definition and defect resistant displays.

The objects are solved by the features of the independent claims. Preferred embodiments are given in the dependent claims.

According to an aspect of the disclosure, there is provided a display panel including a substrate including a plurality of pixels, each having a first pattern area and a second pattern area surrounding the first pattern area, an insulating layer disposed on the substrate and including a first intaglio pattern disposed in the first pattern area, and a pair of light-emitting elements disposed on the first intaglio pattern of the insulating layer, wherein the first intaglio pattern may have a length in a first direction and a length in a second direction, and respective light-emitting areas of the pair of light-emitting elements may be offset in different directions from an extension line in the first direction or the second direction from a center of the first intaglio pattern.

In one or more embodiments, the display panel may have a plane with a longitudinal direction and a width direction, and a cross section in a thickness direction.

In one or more embodiments, a shortest distance between centers of the pixels adjacent in the longitudinal direction or the width direction of the display panel may be set as a first pitch.

In one or more embodiments, a shortest distance between centers of the pair of light-emitting elements may be set as a first distance.

In one or more embodiments, the first distance may be less than or equal to 1/2 of the first pitch.

In one or more embodiments, the pair of light-emitting elements may be arranged in the width direction of the display panel.

In one or more embodiments, the respective light-emitting areas of the pair of light-emitting elements may be disposed to face each other.

In one or more embodiments, the pair of light-emitting elements may be arranged in the longitudinal direction of the display panel.

In one or more embodiments, the respective light-emitting areas of the pair of light-emitting elements may be disposed in a diagonal direction.

In one or more embodiments, the display panel may further comprise a first adhesive layer disposed between the first intaglio pattern of the insulating layer and the pair of light-emitting elements.

In one or more embodiments, the first adhesive layer may include an upper surface in contact with the pair of light-emitting elements; a lower surface in contact with the insulating layer; and a groove adjacent to the pair of light-emitting elements and defined by a bottom surface between the upper surface and the lower surface and a side surface extending between the upper surface and the bottom surface.

In one or more embodiments, a first thickness may be formed between the lower surface and the bottom surface.

In one or more embodiments, a second thickness greater than the first thickness may be formed between the upper surface and the lower surface.

In one or more embodiments, the insulating layer may further include a second intaglio pattern disposed on one side of the first intaglio pattern in the second pattern area.

In one or more embodiments, the first intaglio pattern may be provided as a plurality of first intaglio patterns.

In one or more embodiments, a shortest distance between centers of the plurality of first intaglio patterns may be set as a second pitch.

In one or more embodiments, a shortest distance between centers of the first intaglio pattern and the second intaglio pattern may be set as a second distance.

In one or more embodiments, the second distance may be less than or equal to 1/2 of the second pitch.

In one or more embodiments, the display panel may further comprise a second adhesive layer on the second intaglio pattern of the insulating layer.

In one or more embodiments, the second adhesive layer may include a lower surface in contact with the insulating layer; and an upper surface opposite to the lower surface of the second adhesive layer.

In one or more embodiments, a third thickness less than the second thickness may be formed between the lower surface and the upper surface of the second adhesive layer.

In one or more embodiments, the first intaglio pattern may include a 1-1 intaglio pattern, and a 1-2 intaglio pattern.

In one or more embodiments, the insulating layer may further include a protruding pattern disposed between the 1-1 intaglio pattern and the 1-2 intaglio pattern in the first pattern area.

In one or more embodiments, the pair of light-emitting elements may be disposed in the 1-1 intaglio pattern and the 1-2 intaglio pattern, respectively.

In one or more embodiments, an area of each of the 1-1 intaglio pattern and the 1-2 intaglio pattern may be greater than an area of the second intaglio pattern.

In one or more embodiments, the insulating layer may further include a first dummy intaglio pattern disposed in the second pattern area.

In one or more embodiments, the second intaglio pattern and the first dummy intaglio pattern may be disposed on one side of the first intaglio pattern to correspond to each pair of light-emitting elements.

In one or more embodiments, the display panel may have a plane with a longitudinal direction and a width direction, and a cross section in a thickness direction.

In one or more embodiments, the insulating layer may further include a second dummy intaglio pattern disposed in the second pattern area.

In one or more embodiments, the second dummy intaglio pattern may be disposed on the plane so as to surround the first intaglio pattern, the second intaglio pattern, and the first dummy intaglio pattern.

In another aspect a method of manufacturing a display panel is provided, comprising preparing a substrate on which an insulating layer including a first intaglio pattern and a second intaglio pattern is formed; forming a first adhesive layer on the first intaglio pattern and forming a second adhesive layer on the second intaglio pattern, wherein the second adhesive layer has a lower adhesion than the first adhesive layer; preparing a donor on which a first light-emitting element and a second light-emitting element are disposed; bonding the donor to the substrate so that the first and second light-emitting elements are bonded to the first intaglio pattern; and detaching the donor from the substrate.

In one or more embodiments, the first intaglio pattern may have a length in a first direction and a length in a second direction.

In one or more embodiments, respective light-emitting areas of the first and second light-emitting elements may be offset in different directions from an extension line in the first direction or the second direction from a center of the first intaglio pattern.

In one or more embodiments, bonding the donor to the substrate so that the first and second light-emitting elements are bonded to the first intaglio pattern may further include: aligning the donor to the substrate so that the first light-emitting element corresponds to the first adhesive layer and the second light-emitting element corresponds to the second adhesive layer; performing a first stamping of the donor onto the substrate; detaching the donor from the substrate while the second light-emitting element remains bonded to the donor; rotating the donor 180 degrees while maintaining a state facing the substrate; performing a second stamping of the 180-degree rotated donor onto the substrate so that the second light-emitting element is spaced apart from the first light-emitting element and corresponds to the first adhesive layer; and detaching the donor from the substrate.

In one or more embodiments, in preparing the donor on which the first light-emitting element and the second light-emitting element are disposed;, the respective light-emitting areas of the first light-emitting element and the second light-emitting element may be offset in the same direction from an extension line in a longitudinal direction or a width direction of the donor.

In one or more embodiments, the display panel may have a plane with a longitudinal direction and a width direction and a cross section in a thickness direction, further including a plurality of pixels.

In one or more embodiments, each of the plurality of pixels may include the first intaglio pattern and the second intaglio pattern.

In one or more embodiments, a shortest distance between centers of the pixels adjacent in the longitudinal direction or the width direction of the display panel may be set as a first pitch.

In one or more embodiments, a shortest distance between centers of the first and second light-emitting elements may be set as a first distance.

In one or more embodiments, the first distance may be less than or equal to 1/2 of the first pitch.

In one or more embodiments, the first and second light-emitting elements may be arranged in the width direction of the display panel.

In one or more embodiments, the respective light-emitting areas of the first and second light-emitting elements may be disposed to face each other.

In one or more embodiments, the first and second light-emitting elements may be arranged in the longitudinal direction of the display panel.

In one or more embodiments, the respective light-emitting areas of the first and second light-emitting elements may be disposed in a diagonal direction.

In one or more embodiments, the first intaglio pattern may be provided as a plurality of first intaglio patterns.

In one or more embodiments, a shortest distance between centers of the plurality of first intaglio patterns may be set as a second pitch.

In one or more embodiments, a shortest distance between centers of the first intaglio pattern and the second intaglio pattern may be set as a second distance.

In one or more embodiments, the second distance may be less than or equal to 1/2 of the second pitch.

## BRIEF DESCRIPTION OF THE SEVERAL VIEWS OF THE DRAWINGS

The above and other objects, features, and advantages of the disclosure will become more apparent to those of ordinary skill in the art by describing embodiments thereof in detail with reference to the accompanying drawings, showing in

FIG. 1 a schematic plan view of a display panel of one embodiment of the application;
FIG. 2 a schematic plan view of a pixel of one embodiment of the application;
FIG. 3 a plan view of a part of a display panel of a first embodiment of the application;
FIG. 4 a cross-sectional view taken along line I-I' of FIG. 3;
FIG. 5 a cross-sectional view taken along line II-II' of FIG. 3;
FIG. 6 a first modified example of the display panel of the first embodiment of the application;
FIG. 7 a second modified example of the display panel of the first embodiment of the application;
FIG. 8 a plan view of a part of a display panel of a second embodiment of the application;
FIG. 9 a cross-sectional view taken along line III-III' of FIG. 8;
FIG. 10 a first modified example of the display panel of the second embodiment of the application;
FIG. 11A a plan view of a part of a display panel of a third embodiment of the application;
FIG.11B plan view illustrating a comparison between first and second intaglio patterns of FIG.11A;
FIG. 12 a cross-sectional view taken along line IV-IV' of FIG. 11A;
FIG. 13 a plan view of a part of a display panel of a fourth embodiment of the application;
FIG. 14 a first modified example of the display panel of the fourth embodiment of the application;
FIG. 15 a plan view of a part of a display panel of a fifth embodiment of the application;
FIG. 16 a first modified example of the display panel of the fifth embodiment of the application;
FIG. 17 a plan view of a part of a display panel of a sixth embodiment of the application;
FIGS. 18A to 18E process plan views of the first embodiment of the application; and
FIGS. 19A to 19F process cross-sectional views of the first embodiment of the application.

## DETAILED DESCRIPTION

Advantages and features of the application and methods of achieving the same should become clear with embodiments described in detail below with reference to the accompanying drawings. However, the application is not limited to the embodiments described below and may be implemented with a variety of different modifications. The embodiments are merely provided to allow those skilled in the art to completely understand the scope of the application, and the application is defined only by the scope of the claims.

The shapes, dimensions, ratios, angles, numbers, and the like disclosed in the drawings for describing the embodiments of the application are merely illustrative and are not limited to the matters shown in the application. Further, in describing the application, detailed descriptions of well-known technologies will be omitted when it is determined that they may unnecessarily obscure the gist of the application.

Terms such as "including", "having", and "composed of" used herein are intended to allow other elements to be added unless the terms are used with the term "only". Any references to the singular may include the plural unless expressly stated otherwise.

Components are interpreted as including an ordinary error range even if no such margin is explicitly stated.

When the positional relationship between two parts is described using the terms such as "on", "above", "below", and "next", one or more parts may be located between the two parts unless the terms are used with the term "immediately" or "directly".

When a device or layer is referred to as being "on" another device or layer, it includes cases in which one device or layer is directly located on the other device or layer or still other device or layer is interposed between the two devices or layers.

Further, although the terms "first", "second", and the like may be used herein to describe various components, the components are not limited by the terms. These terms are used only to distinguish one component from another component. Therefore, a first component described below may be a second component within the technical scope of the present application.

Like reference numerals refer to like elements throughout the application.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the disclosure is not limited to the size and the thickness of the component illustrated, but it is to be noted that the relative dimensions including the relative size, location, and thickness of the components illustrated in various drawings submitted herewith are part of the disclosure.

As used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

The features of various embodiments of the application may be partially or entirely combined with each other. The embodiments may be technically linked and operate in various ways and may be carried out independently of or in association with each other.

As used herein, the term "device" may include a display device such as a liquid crystal module (LCM) including a display panel and a driving part for driving the display panel, and an organic light-emitting display module (OLED module). In addition, the display device may include a notebook computer, a television, a computer monitor, a vehicle apparatus, an automotive apparatus, an equipment apparatus including one or more components or parts for a vehicle, a set electronic device (or a set device or a set apparatus) including a mobile electronic device such as a smartphone, an electronic pad, etc., which is a complete product or final product including the LCM, the OLED module, or the like.

Accordingly, the display device used herein may include a display device itself, such as the LCM, the OLED module, or the like and an application product including the LCM, the OLED module, or the like or a set device that is a device for end consumers.

**In** some embodiments, the LCM or the OLED module, which includes a display panel, a driving part, and the like, may be referred to as a "display device," and an electronic device including the LCM or the OLED module as a complete product may be referred to as "set device". For example, the display device may include a display panel of a liquid crystal display (LCD) or an OLED, and a source printed circuit board (PCB) that is a controller for driving the display panel. The set device may further include a set PCB that is a set controller for controlling the entire set device, while being electrically connected to the source PCB.

The display panel used in the embodiments may include all types of display panels, such as an LCD panel, an OLED display panel, and an electroluminescent display panel. However, the embodiments of the application are not limited thereto.

Features of various embodiments of the application may be partially or overall coupled to or combined with each other, and may be variously inter-operated with each other and driven technically as those skilled in the art can sufficiently understand. The embodiments of the application may be carried out independently from each other, or may be carried out together in a related relationship.

Hereinafter, various embodiments of the disclosure will be described in detail with reference to the accompanying drawings. The scale of the components shown in the drawings may be different from the actual scale for convenience of description, and thus, is not limited to the scale shown in the drawings.

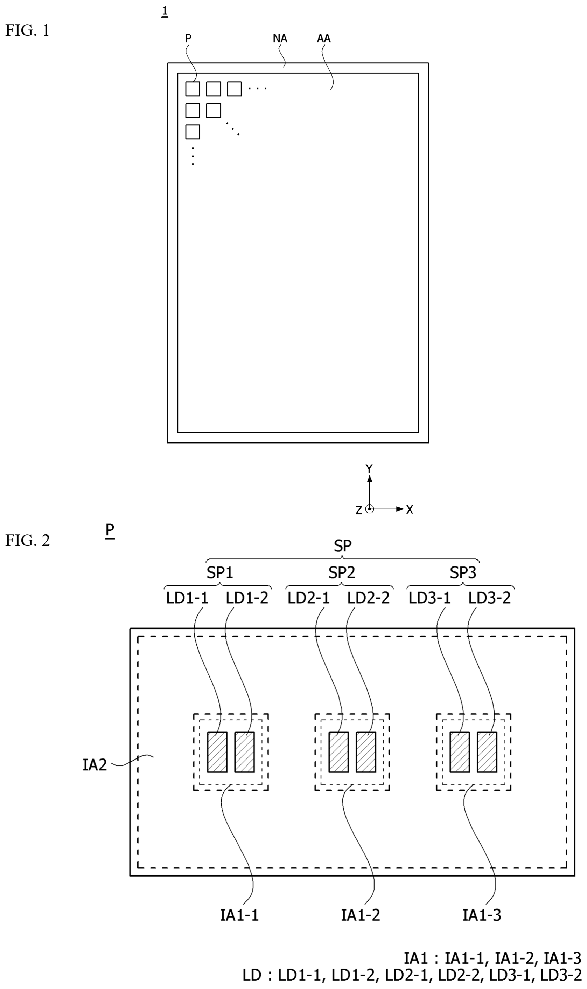

FIG. 1 is a schematic plan view of a display panel of one embodiment of the application, and FIG. 2 is a schematic plan view of a pixel of one embodiment of the application.

Referring to FIGS. 1 and 2, a horizontal direction X and a vertical direction Y of a display panel 1 may be a longitudinal direction and a width direction of the display panel 1, respectively. In addition, the horizontal direction X and the vertical direction Y of the display panel 1 may also be expressed as a row direction and a column direction, respectively. A thickness direction Z may refer to a direction perpendicular to a plane having the horizontal direction X and the vertical direction Y of the display panel 1. In addition, the display panel 1 may have a cross section in the thickness direction Z.

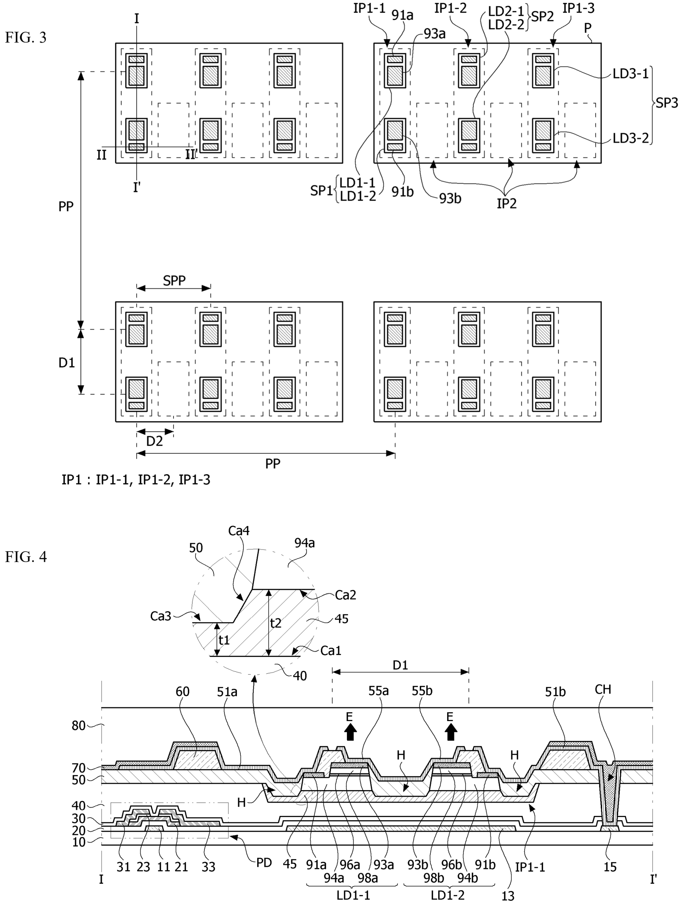

Referring to FIGS. 1 and 2, the display panel 1 of one embodiment of the application may include: a substrate 10 (see FIG. 4) that includes a plurality of pixels P (specially, on which a plurality of pixels P are disposed), each of the plurality of pixels P includes a first pattern area IA1 and a second pattern area IA2 surrounding the first pattern area IA1; an insulating layer 40 (see

FIG. 4) disposed on the substrate 10 and including a first intaglio pattern IP1 (see FIG. 3) disposed in the first pattern area IA1; and a pair (for example, one pair, but not limited thereto) of light-emitting elements LD disposed on the first intaglio pattern IP1 of the insulating layer 40. The first intaglio pattern IP1 has a length in a first direction (for example, the longitudinal direction of the display panel) and a length in a second direction (for example, the width direction of the display panel) different from the first direction, and light-emitting areas E (see FIG. 4) of the pair of light-emitting elements LD may be offset in different directions (for example, in opposite directions) with respect to an extension line in the first direction or the second direction from the center of the first intaglio pattern IP1.

The display panel 1 may implement information, videos, and/or images provided to a user. For example, the display panel 1 may include a display area AA and a non-display area NA. The substrate 10 (see FIG. 4) may include the display area AA and the non-display area NA.

The substrate 10 may be formed of an insulating material. For example, the substrate 10 may be formed of glass, resin, or the like. The substrate 10 may be formed of a material that has flexibility. The substrate 10 may be formed of a plastic material having flexibility, such as polyimide (PI). However, the embodiments of the application are not limited thereto.

The display area AA may be an area in which an image is displayed. The display area AA of the substrate 10 or the display panel 1 may be configured in various shapes depending on the design of the display device. For example, the display area AA may be configured in a rectangular shape with four rounded corners, but the embodiments of the present application are not limited thereto. For another example, the display area AA may be configured in a rectangular shape with four right-angled corners, a circular shape, or the like, but the embodiments of the application are not limited thereto.

The display area AA may include the plurality of pixels P. Each of the plurality of pixels P may be composed of a plurality of sub-pixel units SP (SP1, SP2, and SP3). A plurality of light-emitting elements LD (LD1-1, LD1-2, LD2-1, LD2-2, or LD3-1, and LD3-2) may be disposed in each of the plurality of sub-pixel units SP. The plurality of light-emitting elements LD may be configured differently depending on the type of display device. For example, when the display device is an inorganic light-emitting display device, the light-emitting element may be a light-emitting diode (LED), a micro light-emitting diode (micro LED), or a mini light-emitting diode (mini LED), but the embodiments of the application are not limited thereto.

The non-display area NA may be an area in which an image is not displayed. Various lines, one or more circuits, and the like for driving the plurality of pixels P of the display area AA may be disposed in the non-display area NA. For example, in the non-display area NA, various lines and driving circuits may be mounted, and a pad part to which an integrated circuit, a printed circuit, or the like is connected may be disposed, but the embodiments of the application are not limited thereto.

For example, the driving circuits may be data driving circuits and/or gate driving circuits, but the embodiments of the application are not limited thereto. Lines through which control signals for controlling the driving circuits are supplied may be disposed on the display panel. For example, the control signals may include various timing signals such as clock signals, input data enable signals, and synchronization signals, but the embodiments of the present application are not limited thereto. The control signals may be received through the pad part. For example, link lines for transmitting signals may be disposed in the non-display area NA. For example, a driving component such as a flexible circuit board and a printed circuit board may be connected to the pad part.

Each of the plurality of pixels P may include one or more sub-pixel units and may be included in the display area AA. The plurality of pixels P may be disposed in a matrix form, forming a plurality of rows and a plurality of columns, but the display panel of the application is not limited thereto.

Each of the plurality of pixels P may include a first sub-pixel unit SP1, a second sub-pixel unit SP2, and a third sub-pixel unit SP3. The plurality of sub-pixel units SP (SP1, SP2, and SP3) may be arranged in various ways. For example, the first to third sub-pixel units SP1, SP2, and SP3 may be arranged side by side in an X-axis direction. The arrangement of the sub-pixel units SP will be specifically described in the following embodiments. However, the number of sub-pixel units SP constituting one pixel P is exemplary, and the embodiments of the application are not limited thereto.

The first to third sub-pixel units SP1, SP2, and SP3 may emit light of different colors. For example, one of the first sub-pixel unit SP1, the second sub-pixel unit SP2, and the third sub-pixel unit SP3 may be a red sub-pixel unit, another may be a green sub-pixel unit, and the remaining one may be a blue sub-pixel unit. The types of the plurality of sub-pixel units are exemplary, and the embodiments of the application are not limited thereto.

Each of the first to third sub-pixel units SP1, SP2, and SP3 may include one or more light-emitting elements LD. The light-emitting element may constitute the sub-pixel of each sub-pixel unit. For example, the first sub-pixel unit SP1 may include a pair of light-emitting elements, which are a 1-1 light-emitting element LD1-1 and a 1-2 light-emitting element LD1-2, the second sub-pixel unit SP2 may include a pair of light-emitting elements, which are a 2-1 light-emitting element LD2-1 and a 2-2 light-emitting element LD2-2, and the third sub-pixel unit SP3 may include a pair of light-emitting elements, which are a 3-1 light-emitting element LD3-1 and a 3-2 light-emitting element LD3-2. However, the number of light-emitting elements included in one sub-pixel unit is exemplary, and the embodiments of the application are not limited thereto.

A plurality of signal lines may be disposed in areas between the plurality of sub-pixel units SP. The plurality of signal lines may extend in a column direction between the plurality of sub-pixel units SP. The plurality of signal lines may be lines that transmit pixel voltages output from pixel driving circuits PD (see FIG. 4) to the plurality of sub-pixel units SP.

For example, the plurality of signal lines may be electrically connected to a plurality of pixel driving circuits PD and pixel electrodes such as first and second pixel electrodes 55a and 55b (see FIG. 4) of the plurality of sub-pixel units SP. The pixel voltages output from the pixel driving circuits PD may be transmitted to the first and second pixel electrodes 55a and 55b of the plurality of sub-pixel units SP through the plurality of signal lines. For example, the first and second pixel electrodes 55a and 55b may be electrodes electrically connected to first electrodes 93a and 93b (see FIG. 4) of the light-emitting elements LD. Thus, the pixel voltages transmitted through the signal lines may be transmitted to the first electrodes 93a and 93b (see FIG. 4) of the light-emitting elements LD through the first and second pixel electrodes 55a and 55b.

The structure of the display panel 1 may be simplified by using the pixel driving circuit, in which a plurality of pixel circuits are integrated, instead of forming a plurality of transistors and a storage capacitor in each of the plurality of sub-pixel units SP. As the circuits disposed in each of the plurality of sub-pixel units SP are integrated into one pixel driving circuit PD, high-efficiency and low-power operation may be possible.

In one embodiment, each of the plurality of pixels P may include one or more first pattern areas IA1 (IA1-1, IA1-2, and IA1-3) and the second pattern area IA2 surrounding the first pattern areas IA1. The first and second pattern areas IA1 and IA2 may include groove-shaped patterns (in other words, intaglio patterns) formed in the insulating layer 40 (see FIG. 4). Here, the groove-shaped patterns may be formed by removing a certain thickness from an upper surface of an insulating layer 40, 140, or 240. I.e. the thickness of the insulating layer 40, 140, or 240 may be thinner in the region of the light emitting elements LD of a certain sub pixel.

Each of the first pattern areas IA1 in one embodiment may correspond to each of the sub-pixel units SP. That is, each of the first pattern areas IA1 in one embodiment may include each of the sub-pixel units SP. When the sub-pixel units SP are provided as a plurality, the one or more first pattern areas IA1 may also be provided as a plurality. For example, the one or more first pattern areas IA1 may include a 1-1 pattern area IA1-1, a 1-2 pattern area IA1-2, and a 1-3 pattern area IA1-3.

One sub-pixel unit SP may be disposed in each of the first pattern areas IA1. One first pattern area IA1 may include a pair of light-emitting elements (for example, one pair of light-emitting elements, but not limited thereto). For example, the 1-1 pattern area IA1-1 may include the 1-1 light-emitting element LD1-1 and the 1-2 light-emitting element LD1-2 of the first sub-pixel unit SP1. For example, the 1-2 pattern area IA1-2 may include the 2-1 light-emitting element LD2-1 and the 2-2 light-emitting element LD2-2 of the second sub-pixel unit SP2. For example, the 1-3 pattern area IA1-3 may include the 3-1 light-emitting element LD3-1 and the 3-2 light-emitting element LD3-2 of the third sub-pixel unit SP3.

The second pattern area IA2 may include one or more second intaglio patterns IP2 (see FIG. 3). The one or more second intaglio patterns IP2 may be disposed to correspond to at least each of the plurality of sub-pixel units SP. For example, when three sub-pixel units (for example, first to third sub-pixel units SP1, SP2, and SP3) are included, at least three second intaglio pattern IP2 may be configured to correspond to each of the three sub-pixel units (for example, the first to third sub-pixel units SP1, SP2, and SP3).

The second intaglio pattern IP2 may serve as a space to which the light-emitting elements LD are temporarily transferred during a stamping process of the pair of light-emitting elements LD. Accordingly, the second intaglio pattern IP2 may be disposed adjacent to the first pattern area IA1 in which the light-emitting elements LD are disposed while maintaining a predetermined distance therefrom.

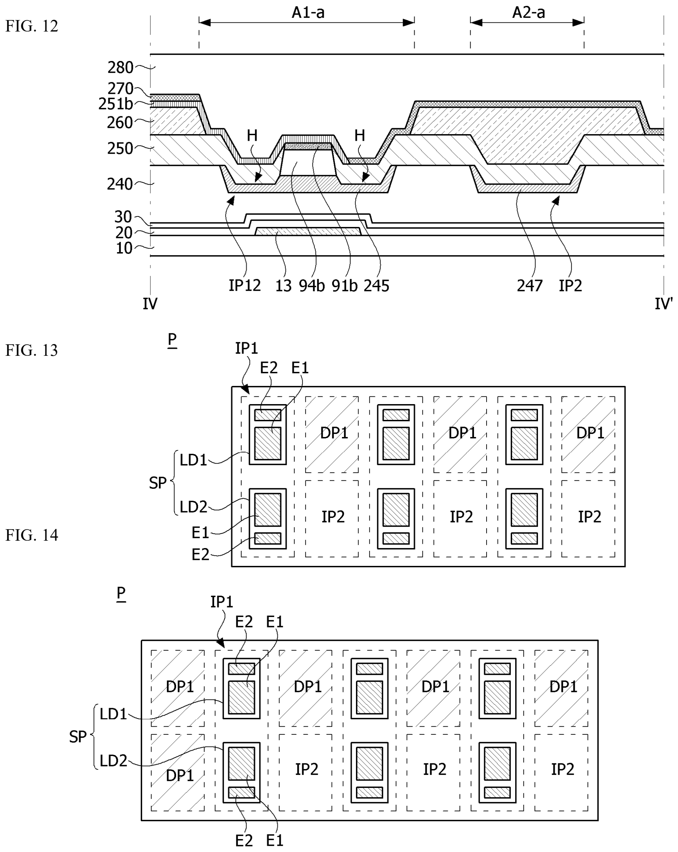

The second pattern area IA2 may further include one or more first dummy patterns DP1 and one or more second dummy patterns DP2 (Fig. 13). The first and second dummy patterns DP1 and DP2 may be dummy areas in which the light-emitting elements LD are not temporarily seated during the stamping process. Accordingly, the first and second dummy patterns DP1 and DP2 may improve a degree of freedom in designing the light-emitting element LD and may improve the uniformity of an adhesive layer in contact with the light-emitting element LD.

In the following embodiments, the first pattern area IA1 and the second pattern area IA2 will be described in detail.

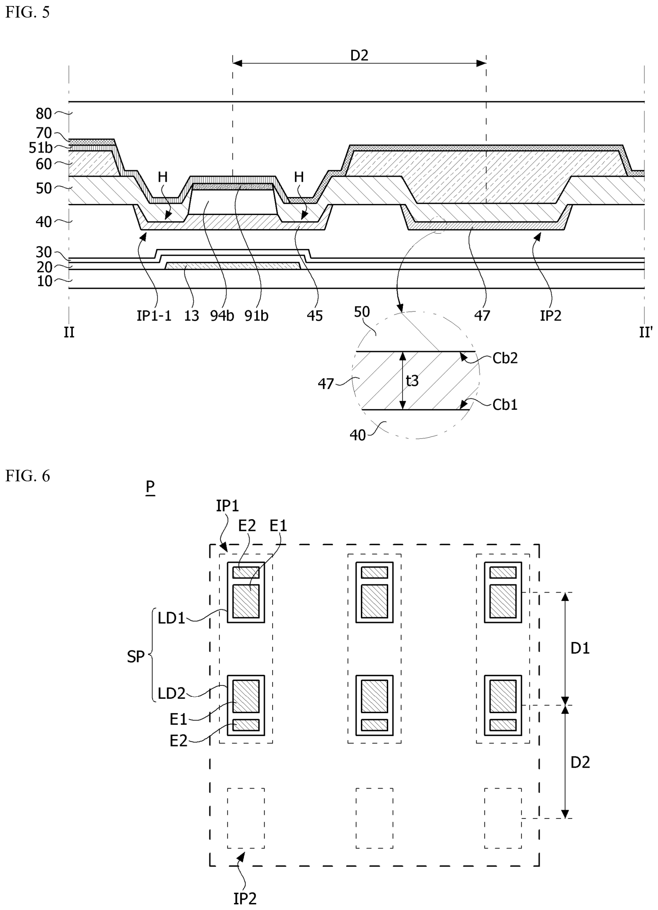

FIG. 3 is a plan view of a part of a display panel of a first embodiment of the application. FIG. 4 is a cross-sectional view taken along line I-I' of FIG. 3, and FIG. 5 is a cross-sectional view taken along line II-II' of FIG. 3.

Referring to FIGS. 3 to 5, the display panel of the first embodiment of the application may include a plurality of pixels P on a substrate 10. The display panel of the first embodiment of the application may include one first intaglio pattern IP1 (IP1-1, IP1-2, or IP1-3) in a first pattern area IA1 of each of the plurality of pixels P and a plurality of second intaglio patterns IP2 in a second pattern area IA2 surrounding the first pattern area IA1. A pair of light-emitting elements LD (LD1-1 and LD1-2, LD2-1 and LD2-2, or LD3-1 and LD3-2) may be disposed on each first intaglio pattern IP1.

The plurality of pixels P may be disposed in a matrix form, forming a plurality of rows and a plurality of columns. However, the application is not limited thereto.

A distance between the pixels P adjacent to each other may form a first pitch PP. The first pitch PP may be measured as a distance between the centers of the light-emitting elements LD at corresponding positions with respect to two adjacent pixels P in a longitudinal or width direction. However, the measurement criteria for the first pitch PP in the application are not limited thereto. For example, the first pitch PP may also be measured as a distance (in other words, shortest distance) between the centers of two adjacent pixels P in the longitudinal or width direction.

Each pixel P may include a plurality of sub-pixel units SP (SP1, SP2, and SP3). The plurality of sub-pixel units SP may include a first sub-pixel unit SP1, a second sub-pixel unit SP2, and a third sub-pixel unit SP3.

The plurality of sub-pixel units SP may be arranged in various ways. The plurality of sub-pixel units SP of the first embodiment may be spaced a predetermined distance apart from each other in a row direction. The second intaglio pattern IP2 may be disposed between the plurality of sub-pixel units SP that are spaced apart from each other.

The distance between the sub-pixel units SP adjacent to each other may form a second pitch SPP. The second pitch SPP may be measured as a distance between the centers of adjacent sub-pixel units SP. The second pitch SPP may be measured as the shortest distance between the centers of the first intaglio patterns IP1 adjacent to each other. However, in the application, the measurement criteria for the second pitch SPP is not limited thereto. For example, the second pitch SPP may also be measured as a distance between the leftmost end of the first sub-pixel unit SP1 and the leftmost end of the second sub-pixel unit SP2. So, the second pitch SPP is shorter than the first pitch PP.

The first to third sub-pixel units SP1, SP2, and SP3 may each include a pair of light-emitting elements LD (LD1-1 and LD1-2, LD2-1 and LD2-2, or LD3-1 and LD3-2). Each pair of light-emitting elements LD may constitute one sub-pixel. For example, the first sub-pixel unit SP1 may include a 1-1 light-emitting element LD1-1 and a 1-2 light-emitting element LD1-2, the second sub-pixel unit SP2 may include a 2-1 light-emitting element LD2-1 and a 2-2 light-emitting element LD2-2, and the third sub-pixel unit SP3 may include a 3-1 light-emitting element LD3-1 and a 3-2 light-emitting element LD3-2.

When using micro LEDs as the light-emitting elements LD, a plurality of micro LEDs may be formed on a wafer and transferred onto the substrate 10 of a display panel 1 to manufacture the display panel 1. During the process of transferring the plurality of light-emitting elements LD having micro sizes from the wafer to the substrate 10, various defects may occur.

For example, in some sub-pixels, a transfer failure may occur in which the light-emitting element LD is not transferred, or a defect may occur in which the light-emitting element LD is transferred out of an intended position due to misalignment. In addition, although the transfer process proceeds normally, the transferred light-emitting element LD itself may be defective. Thus, in consideration of the defects that may occur during the transfer process of a plurality of light-emitting elements LD, a plurality of light-emitting elements LD of the same type may be transferred onto one sub-pixel. A lighting test may be performed on the plurality of light-emitting elements LD, and ultimately, only one light-emitting element LD that is determined to be normal may be used.

One of the pair of light-emitting elements LD may be a main (or primary) light-emitting element LD, and the other may be a redundancy light-emitting element LD. The redundancy light-emitting element LD may be a spare light-emitting element LD transferred in preparation for a defective light-emitting element LD. When the main light-emitting element LD is defective, the redundancy light-emitting element LD may be used as a replacement. Accordingly, by transferring both the main light-emitting element LD and the redundancy light-emitting element LD onto one sub-pixel unit SP, the degradation of display quality due to the failure of the main light-emitting element LD or the redundancy light-emitting element LD may be minimized. Since color expression in the sub-pixel unit is possible even when only one of the main sub-pixel and the redundancy sub-pixel is driven, yield can be improved.

For example, the 1-1 light-emitting element LD1-1, the 2-1 light-emitting element LD2-1, and the 3-1 light-emitting element LD3-1 may be used as the main light-emitting elements (or main sub-pixels), and the 1-2 light-emitting element LD1-2, the 2-2 light-emitting element LD2-2, and the 3-2 light-emitting element LD3-2 may be used as the redundancy light-emitting elements (or redundancy sub-pixels).

The pair of light-emitting elements LD may be arranged in various ways. The pair of light-emitting elements LD of the first embodiment may be disposed side by side in a Y-axis direction.

The light-emitting areas of the pair of light-emitting elements LD may be disposed (or oriented) in different directions. For example, when the first intaglio pattern IP1 (IP1-1, IP1-2, or IP1-3) has a length in a first direction and a length in a second direction different from the first direction, the light-emitting areas of the pair of light-emitting elements LD may be disposed to be offset in different directions (for example, in opposite directions, but not limited thereto) with respect to an extension line in the first direction or the second direction from the center of the first intaglio pattern IP1. The pair of light-emitting elements LD of the first embodiment may be disposed such that their light-emitting areas E face each other.

The light-emitting area E may tend to be biased toward one side of the light-emitting element LD. The light-emitting areas E of the light-emitting elements LD may be biased toward the sides in which active layers 96a and 96b are located. The active layers 96a and 96b of the light-emitting elements LD may overlap first electrodes 93a and 93b of the light-emitting elements LD, respectively. Accordingly, the light-emitting areas E according to the application may overlap the first electrodes 93a and 93b of the light-emitting elements LD.

In the display panel of the first embodiment of the application, the light-emitting areas E of the pair of light-emitting elements LD may be disposed to face each other. As the pair of light-emitting elements LD are disposed side by side in the Y-axis direction, the light-emitting area E of the pair of light-emitting elements LD may also be disposed adjacent to each other in Y-axis direction. For example, the pair of light-emitting elements LD of the first embodiment may be disposed such that their light-emitting areas E face each other, and may be vertically symmetrical with respect to an arbitrary X-axis direction.

The display panel of the first embodiment of the application can have a uniform dispersion of color wavelengths. When the light-emitting areas E of the pair of light-emitting elements LD are disposed adjacent to each other, a color shift in the pair of light-emitting elements LD may be significantly reduced. Accordingly, the display panel of the application may have the effect of preventing stains in stamp-area units from being visible. Here, the stains in stamp-area units may refer to color differences caused by various factors, such as the non-uniform dispersion of color wavelengths.

The pair of light-emitting elements LD may be spaced a first distance D1 apart. The first distance D1 may be measured as a distance (in other words, shortest distance) between the centers of the pair of light-emitting elements. However, the measurement criteria for the first distance D1 in the present application are not limited thereto. For example, the first distance D1 may also be measured as a distance between an upper side end of the 1-1 light-emitting element LD1-1 and an upper side end of the 1-2 light-emitting element LD1-2.

The first distance D1 of the display panel of the application may be configured to be smaller than the binocular resolution for a pixel distance based on a viewing distance. The first distance D1 may be derived by calculating a minimum perceptible pixel interval at the viewing distance. The binocular resolution may also be referred to as binocular acuity, binocular resolving power, or the like. The binocular resolution may refer to the visual ability that indicates how accurately details can be distinguished when both eyes work together to recognize an object. The binocular resolution for the pixel distance may be measured as an angle between the closest perceivable pixels on a vertical line, assuming that the pixels are located along the vertical line between a viewer and a screen.

For example, the binocular resolution for the pixel distance, based on a viewer with a visual acuity of 1.0, may be 1/60°. For another example, the binocular resolution for pixel distance, based on a viewer with a visual acuity of 2.0, may be 1/120°.

A minimum perceptible pixel interval $\alpha$ at the viewing distance may be calculated using a binocular resolution BR, a viewing distance VD, or the like. The viewing distance VD may refer to a vertical distance between the viewer and the screen. The minimum perceptible pixel interval $\alpha$ at

$$[\text{Equation 1}] \quad \alpha = 2 * VD * \tan \ (\text{radians}((BR) * (1/2)))$$

the viewing distance VD may be calculated using Equation 1 below,

For example, when the viewing distance is 3 m and the binocular resolution is 1/60° based on a visual acuity of 1.0, by substituting VD = 3 and BR = 1/60 into Equation 1, the minimum perceptible pixel interval $\alpha$ at the viewing distance is derived as approximately 872.6646.

The minimum perceptible pixel interval $\alpha$ at the viewing distance may determine a first pitch PP, and based on the determined first pitch PP, the first distance D1, which is the distance between the pair of light-emitting elements, may be determined.

To ensure that a distance difference between the pixels P is not perceptible to the viewer, the first pitch PP may be configured to be smaller than the minimum perceptible pixel interval $\alpha$ at the viewing distance. For example, the first pitch PP may be configured to be smaller than 1/2 of the minimum perceptible pixel interval $\alpha$ at the viewing distance.

The first distance D1 between the pair of light-emitting elements may be set to a value smaller than the first pitch PP. For example, the first distance D1 may be at most 1/2 of the first pitch PP. Alternatively, the first distance D1 may be less than or equal to 1/10 of the first pitch PP. However, the first distance D1 in the display panel of the present application is not limited thereto and may be set as a distance less than 1/10 of the first pitch PP, such as 1/11, 1/12, 1/13,..., or 1/n (where n is a number greater than 10) of the first pitch PP. The first distance D1 between the pair of light-emitting elements may be set to position a first light-emitting element and a second light-emitting element as close to each other as possible.

In the display panel of the application, the pair of light-emitting elements LD may be transferred using a twice stamping method (in other words, a stamping method comprising a first stamping process and a second stamping process), thereby allowing the first distance D1 to be formed smaller than the binocular resolution. The implemented first distance D1 may be set to be less than or equal to 1/2 of the first pitch PP and preferably less than or equal to 1/10 of the first pitch PP. Alternatively, the first distance D1 may be set to be less than or equal to 1/2 and greater than or equal to 1/10 of the first pitch PP. Accordingly, in the display panel of the application, even when defects continuously occur in the sub-pixels of every sub-pixel unit, it may be impossible for the viewer to perceive stains caused by the defects.

By adopting a twice stamping method, the productivity (capa drop) for transferring the pair of light-emitting elements LD disposed (or oriented) in different directions may be improved. In the second stamping method, a distance (a second distance D2) between each first intaglio pattern IP1 (IP1-1, IP1-2, or IP1-3) and the second intaglio pattern IP2 may be set to a predetermined distance to prevent cluster defects during a first stamping process.

Referring to FIG. 3 in conjunction with FIG. 2, the display panel according to the first embodiment of the application may include a 1-1 intaglio pattern IP1-1, a 1-2 intaglio pattern IP1-2, and a 1-3 intaglio pattern IP1-3 in the plurality of first pattern areas IA1-1, IA1-2, and IA1-3 (see FIG. 2), and may include a plurality of second intaglio patterns IP2 in the second pattern area IA2 (see FIG. 2).

The plurality of first intaglio patterns IP1 may include the 1-1 intaglio pattern IP1-1, the 1-2 intaglio pattern IP1-2, and the 1-3 intaglio pattern IP1-3. The 1-1 to 1-3 intaglio patterns IP1-1, IP1-2, and IP1-3 may be spaced apart from each other with the second intaglio pattern IP2 interposed therebetween. The second intaglio pattern IP2 may be disposed on one side of each of the 1-1 to 1-3 intaglio patterns IP1-1, IP1-2, and IP1-3. The 1-1 intaglio pattern IP1-1 and the second intaglio pattern IP2 will be described in detail as an example with reference to the cross-sectional views of FIGS. 4 and 5.

Referring to FIGS. 4 and 5, the display panel according to one embodiment of the application may include a plurality of insulating layers (for example, first to sixth insulating layers 20, 30, 40, 50, 60, and 70) on the substrate 10, a driving circuit including at least one transistor T between the plurality of insulating layers (for example, the first to sixth insulating layers 20, 30, 40, 50, 60, and 70), adhesive layers (for example, first and second adhesive layers 45 and 47), and the pair of light-emitting elements LD (LD1-1 and LD1-2). The plurality of insulating layers (for example, the first to sixth insulating layers 20, 30, 40, 50, 60, and 70) may sequentially include a first insulating layer 20, a second insulating layer 30, a third insulating layer 40, a fourth insulating layer 50, a fifth insulating layer 60, and a sixth insulating layer 70 on the substrate 10.

The at least one transistor T may include a gate electrode 11, a semiconductor layer 21, an ohmic contact layer 23, a source electrode 31, and a drain electrode 33.

The gate electrode 11 may be disposed on the substrate 10. The gate electrode 11 may be formed on the same layer as a reflective layer 13 and a common power line 15 on the substrate 10. For example, the gate electrode 11 may be a single layer or a multilayer formed of any one of molybdenum (Mo), aluminum (Al), chromium (Cr), gold (Au), titanium (Ti), nickel (Ni), neodymium (Nd), and copper (Cu), or an alloy thereof.

The semiconductor layer 21 may be disposed on the first insulating layer 20 so as to overlap the gate electrode 11. For example, the semiconductor layer 21 may be formed of a semiconductor material composed of any one of amorphous silicon, polycrystalline silicon, an oxide, and an organic material, but the present application is not limited thereto.

The ohmic contact layer 23 may be disposed on the semiconductor layer 21. The ohmic contact layer 23 is configured for forming an ohmic contact between the semiconductor layer 21 and the source and drain electrodes 31 and 33 and may be omitted.

The source electrode 31 may be disposed on the ohmic contact layer 23 so as to overlap one side of the semiconductor layer 21. The drain electrode 33 may be disposed on the other side of the ohmic contact layer 23 so as to be spaced apart from the source electrode 31. The source and drain electrodes 31 and 33 may be formed together. For example, the source and drain electrodes 31 and 33 may be formed as a single layer of a metal material, such as molybdenum (Mo), aluminum (Al), chromium (Cr), gold (Au), titanium (Ti), nickel (Ni), neodymium (Nd), copper (Cu), or an alloy thereof, or as a multilayer structure using these materials.

The reflective layer 13 on the substrate 10 may be provided at least below the light-emitting area of each of the light-emitting elements LD1-1 and LD1-2. For example, the reflective layer 13 may overlap both the light-emitting elements LD1-1 and LD1-2 and may be formed as a single pattern. However, the present application is not limited thereto.

The common power line 15 on the substrate 10 may extend from the non-display area NA to the display area AA. The common power line 15 may supply pixel driving power provided from a pad part of the non-display area NA to the pair of light-emitting elements LD.

The first insulating layer 20 may cover the gate electrode 11, the reflective layer 13, the common power line 15, and the like formed on the substrate 10. The first insulating layer 20 may be formed at least over the entire display area AA. The first insulating layer 20 may refer to a commonly used gate insulating layer. For example, the first insulating layer 20 may be formed as a single layer or multiple layers formed of an inorganic material and may include silicon oxide (SiOx), silicon nitride (SiNx), or the like. However, the present application is not limited thereto.

The second insulating layer 30 may cover the driving circuit including at least one transistor T on the first insulating layer 20. The second insulating layer 30 may be formed at least over the entire display area AA and may be in contact with the first insulating layer 20 in some areas. The second insulating layer 30 may refer to a commonly used interlayer insulating layer. For example, the second insulating layer 30 may be formed of an inorganic material such as silicon oxide (SiOx) or silicon nitride (SiNx) or may be formed of an organic material such as benzocyclobutene or photo acryl. The second insulating layer 30 may be omitted. However, the present application is not limited thereto.

The third insulating layer 40 may be disposed on the second insulating layer 30. The third insulating layer 40 may be formed at least over the entire display area AA. For example, the third insulating layer 40 may be formed of an organic material such as benzocyclobutene or photo acryl. However, the present application is not limited thereto.

The third insulating layer 40 may include at least one first intaglio pattern IP1 (IP1-1, IP1-2, or IP1-3) and at least one second intaglio pattern IP2. The first and second intaglio patterns IP1 and IP2 may be formed by partially removing the thickness of the third insulating layer 40 from its upper surface. The first and second intaglio patterns IP1 and IP2 may be spaces in which the one or more or a plurality of light-emitting elements LD are seated (that is, seating spaces) during the stamping process. The term "seating space" does not necessarily refer to a space in which the light-emitting element LD is fixed. For example, the seating space may include both a space in which the light-emitting element LD is temporarily seated and then detached during the stamping process, and a space to which the light-emitting element LD is transferred and fixed.

The first and second intaglio patterns IP1 and IP2 may guide positions of the plurality of light-emitting elements LD in the transfer process of transferring the plurality of light-emitting elements LD to the display panel 1. In the transfer process of transferring the plurality of light-emitting elements LD, the plurality of light-emitting elements LD may be transferred onto the first and second intaglio patterns IP1 and IP2.

For example, the pair of light-emitting elements LD1-1 and LD1-2 may be disposed on the 1-1 intaglio pattern IP1-1 with a first adhesive layer 45 interposed therebetween. The 1-1 intaglio pattern IP1-1 may have a predetermined area sufficient to accommodate the pair of light-emitting elements LD1-1 and LD1-2, which are spaced the first distance D1 apart. For example, when each light-emitting element LD is formed with a greater length in a Y-axis direction than in an X-axis direction, and the pair of light-emitting elements LD1-1 and LD1-2 are disposed side by side in the Y-axis direction, the 1-1 intaglio pattern IP1-1 may be formed with a greater length in the Y-axis direction than in the X-axis direction.

A second adhesive layer 47 may be formed on each second intaglio pattern IP2. In the display panel according to the first embodiment of the application, one second intaglio pattern IP2 may be formed to correspond to each 1-1 intaglio pattern IP1-1. The second intaglio pattern IP2 may be an area in which one of the pair of light-emitting elements LD1-1 and LD2-1, which are formed on the 1-1 intaglio pattern IP1-1, is temporarily seated during the stamping process. Thus, the second intaglio pattern IP2 according to the embodiment may have a smaller area in the plane of the display panel than the 1-1 intaglio pattern IP1-1.

The 1-1 intaglio pattern IP1-1 and the second intaglio pattern IP2 may be spaced the second distance D2 apart. In the twice stamping method, during the first stamping process, a plurality of LED chips may be transferred onto the 1-1 intaglio pattern IP1-1 and the second intaglio pattern IP2. The second distance D2 may be a predetermined distance for preventing cluster defects of the light-emitting elements during the first stamping process. For example, the second distance D2 may be less than or equal to 1/2 of the second pitch SPP, which is the shortest distance between the sub-pixel units SP adjacent to each other.

The first and second adhesive layers 45 and 47 may be disposed on the first and second intaglio patterns IP1 and IP2 of the third insulating layer 40, respectively. The first and second adhesive layers 45 and 47 may include the first adhesive layer 45 disposed on the first intaglio patterns IP1 and the second adhesive layer 47 disposed on the second intaglio pattern IP2. For example, the first and second adhesive layers 45 and 47 may include an optically clear adhesive (OCA), an optically clear resin (OCR), a pressure sensitive adhesive (PSA), or the like. However, the application is not limited thereto.

The first adhesive layer 45 may be disposed on the first intaglio patterns IP1. The first adhesive layer 45 may be formed along side and bottom surfaces of the 1-1 intaglio pattern IP1-1. The first adhesive layer 45 may include a lower surface Ca1 in contact with a bottom surface of the 1-1 intaglio pattern IP1-1, an upper surface Ca2 in contact with the first and second light-emitting elements LD1-1 and LD1-2, and a groove H. The groove H of the first adhesive layer 45 may include a bottom surface Ca3 more adjacent to the substrate 10 than the upper surface Ca2, and a side surface Ca4 between the upper surface Ca2 and the bottom surface Ca3.

To improve the contact capability of the first and second electrodes 93a and 93b, 91a, and 91b of the first and second light-emitting elements LD1-1 and LD1-2, an etching process may be performed after transferring the first and second light-emitting elements LD1-1 and LD1-2 onto the adhesive layer. In this process, as the adhesive layer in an area not overlapping with the first and second light-emitting elements LD1-1 and LD1-2 is etched, the groove H of the first adhesive layer 45 may be formed.

Accordingly, a thickness difference may occur in the first adhesive layer 45. In the first adhesive layer 45, a first thickness t1 may be formed between the lower surface Ca1 and the bottom surface Ca3 of the groove H, and a second thickness t2 may be formed between the upper surface Ca2 and the lower surface Ca1. As a result of the etching process, the first thickness t1 may be formed to be less than the second thickness t2.

The second adhesive layer 47 may be disposed on the second intaglio pattern IP2. The second adhesive layer 47 may be formed along side and bottom surfaces of the second intaglio pattern IP2. The second intaglio pattern IP2 may include a lower surface Cb1 in contact with the third insulating layer 40 and an upper surface Cb2 opposite to the lower surface Cb1. A third thickness t3 may be formed between the upper surface Cb2 and the lower surface Cb1 of the second intaglio pattern IP2. When the first and second adhesive layers 45 and 47 are formed in the same process, as a result of the etching process, the third thickness t3 may be similar to (for example, equal to) the first thickness t1 and be less than the second thickness t2.

The first and second adhesive layers 45 and 47 may be disposed over the entire third insulating layer 40 including the 1-1 intaglio pattern IP1-1 and the second intaglio pattern IP2, before the etching process. The adhesive layer disposed on an upper surface of the third insulating layer 40, except for the 1-1 intaglio pattern IP1-1 and the second intaglio pattern IP2, may be removed by the etching process. However, the display panel of the present application is not limited thereto, and an adhesive layer material may be partially present on the upper surface of the third insulating layer 40.

The pair of 1-1 and 1-2 light-emitting elements LD1-1 and LD1-2 may be disposed on the first adhesive layer 45. The 1-1 and 1-2 light-emitting elements LD1-1 and LD1-2 according to one embodiment may respectively include light-emitting layers, the first electrodes (or anode terminals) 93a and 93b, and second electrodes (or cathode terminals) 91a and 91b.

The light-emitting layers may emit light through recombination of electrons and holes caused by current flowing between the first electrodes 93a and 93b and the second electrodes 91a and 91b. The light-emitting layers according to one embodiment may include first semiconductor layers 94a and 94b, the active layers 96a and 96b, and second semiconductor layers 98a and 98b.

The first semiconductor layers 94a and 94b may provide electrons to the active layers 96a and 96b. For example, the first semiconductor layers 94a and 94b may be formed of an n-type GaN-based semiconductor material, and the n-type GaN-based semiconductor material may include GaN, AlGaN, InGaN, AlInGaN, or the like. Here, impurities used for doping the first semiconductor layers 94a and 94b may include Si, Ge, Se, Te, C, and the like.

The active layer 96a may be provided on one side of the first semiconductor layer 94a, and the active layer 96b may be provided on one side of the first semiconductor layer 94b. The active layers 96a and 96b may have a multi-quantum well (MQW) structure that includes well layers and barrier layers with a higher bandgap than the well layers. For example, the active layers 96a and 96b may have a multi-quantum well (MQW) structure, such as InGaN/GaN.

The second semiconductor layers 98a and 98b may be respectively provided on the active layers 96a and 96b, and may supply holes to the active layers 96a and 96b, respectively. For example, the second semiconductor layers 98a and 98b may be formed of a p-type GaN-based semiconductor material, and the p-type GaN-based semiconductor material may include GaN, AlGaN, InGaN, AlInGaN, or the like. Here, impurities used for doping the second semiconductor layers 98a and 98b may include Mg, Zn, Be, and the like.

The first electrodes 93a and 93b may be provided on the second semiconductor layers 98a and 98b, respectively. The first electrodes 93a and 93b may be connected to the source electrode 31 of at least one transistor T.

The second electrode 91a may be provided on the other side of the first semiconductor layer 94a to be electrically separated from the active layer 96a and the second semiconductor layer 98a, and the second electrode 91b may be provided on the other side of the first semiconductor layer 94b to be electrically separated from the active layer 96b and the second semiconductor layer 98b. The second electrodes 91a and 91b may be connected to the common power line 15.

For example, each of the first electrodes 93a and 93b and each of the second electrodes 91a and 91b may be formed of a material that includes one or more of metal materials such as Au, W, Pt, Si, Ir, Ag, Cu, Ni, Ti, or Cr, or alloys thereof. For another example, each of the first electrodes 93a and 93b and each of the second electrodes 91a and 91b may be formed of a transparent conductive material, and the transparent conductive material may include indium tin oxide (ITO) or indium zinc oxide (IZO), but the present application is not limited thereto.

The 1-1 and 1-2 light-emitting elements LD1-1 and LD1-2 may emit light through the recombination of electrons and holes resulting from the current flowing between the respective first electrodes 93a and 93b and the respective second electrodes 91a and 91b. For example, light emitted from the 1-1 and 1-2 light-emitting elements LD1-1 and LD1-2 may pass through the respective first electrodes 93a and 93b and the respective second electrodes 91a and 91b and may be emitted to the outside. The light emitted from the 1-1 and 1-2 light-emitting elements LD1-1 and LD1-2 may pass through the respective first electrodes 93a and 93b and the respective second electrodes 91a and 91b in a second direction opposite to a first direction toward the bottom surface of the 1-1 intaglio pattern IP1-1 to display an image.

The fourth insulating layer 50 may be disposed on the first and second adhesive layers 45 and 47 and on the third insulating layer 40 on which the light-emitting element LD is formed. The fourth insulating layer 50 may be formed over the entire display area AA, excluding an upper surface of the light-emitting element LD. The fourth insulating layer 50 may expose the upper surface of the light-emitting element LD to allow contact with the first and second electrodes 91a, 91b, 93a, and 93b on the upper surface of the light-emitting element LD.

The fourth insulating layer 50 may be formed of a black organic pigment as a photoresist material. The fourth insulating layer 50 may have a structure surrounding the light-emitting areas of the light-emitting elements LD and may be formed of a material including a black pigment. For example, the fourth insulating layer 50 may be formed of an inorganic material such as silicon oxide (SiOx) or silicon nitride (SiNx) including a black pigment, or an organic material such as benzocyclobutene or photo acryl. However, the present application is not limited thereto.

The fifth insulating layer 60 may be disposed on a portion of the fourth insulating layer 50 and may be disposed at least between the first and second electrodes 93a and 91a of the 1-1 light-emitting element LD1-1 and at least between the first and second electrodes 93b and 91b of the 1-2 light-emitting element LD1-2. The fifth insulating layer 60 may prevent a short circuit between the first electrodes 93a and 93b and the second electrodes 91a and 91b. An upper surface of the fifth insulating layer 60, which is disposed on a portion of the fourth insulating layer 50, may be positioned higher than the upper surface of the light-emitting element LD in a Z-axis direction relative to the substrate 10. For example, the fifth insulating layer 60 may protrude beyond the light-emitting element LD in the Z-axis direction relative to the substrate 10.

For example, the fifth insulating layer 60 may be formed of an organic material such as benzocyclobutene or photo acryl. However, the application is not limited thereto.

First and second pixel electrodes 55a and 55b and first and second common electrodes 51a and 51b may be disposed on the substrate 10 on which the fifth insulating layer 60 is formed.

The first pixel electrode 55a in contact with the 1-1 light-emitting element LD1-1 and the second pixel electrode 55b in contact with the 1-2 light-emitting element LD1-2 may be integrally formed and connected in series. However, the present application is not limited thereto. For example, the first and second pixel electrodes 55a and 55b may be formed individually and connected in parallel.

The first and second pixel electrodes 55a and 55b may be connected in series, and thus, the two first electrodes 93a and 93b may be connected to the source electrode 31 of at least one transistor T. The first and second pixel electrodes 55a and 55b may be defined as anodes. For example, the first and second pixel electrodes 55a and 55b may be provided on upper and side surfaces of the fifth insulating layer 60 overlapping the first electrodes 93a and 93b of the 1-1 and 1-2 light-emitting elements LD1-1 and LD1-2, and on side and bottom surfaces of the fourth insulating layer 50 disposed between the 1-1 and 1-2 light-emitting elements LD1-1 and LD1-2.

A portion of the first and second pixel electrodes 55a and 55b may be electrically connected to the source electrode 31 of at least one transistor T through contact holes provided through the second and third insulating layers 30 and 40. The first pixel electrode 55a may be connected to the first electrode 93a of the 1-1 light-emitting element LD1-1 exposed between the fourth insulating layer 50 and the fifth insulating layer 60. The second pixel electrode 55b may be electrically connected to the first electrode 93b of the 1-2 light-emitting element LD1-2 exposed between the fourth insulating layer 50 and the fifth insulating layer 60.

Accordingly, the first electrodes 93a and 93b may be electrically connected to the source electrode 31 of at least one transistor T through the first and second pixel electrodes 55a and 55b. For example, when the display device employs a top emission scheme, the first and second pixel electrodes 55a and 55b may be formed of a transparent conductive material. For example, when the display device employs a bottom emission scheme, the first and second pixel electrodes 55a and 55b may be formed of a reflective conductive material.

The transparent conductive material may include indium tin oxide (ITO), indium zinc oxide (IZO), or the like, but the present application is not limited thereto. The reflective conductive material may include Al, Ag, Au, Pt, Cu, or the like, but the present application is not limited thereto. When the first and second pixel electrodes 55a and 55b are formed of a reflective conductive material, the first and second pixel electrodes 55a and 55b may be formed as a single layer including the reflective conductive material or a multilayer in which the single layer is stacked.

The first and second common electrodes 51a and 51b may be electrically connected to each other. For example, the first and second common electrodes 51a and 51b may be integrally formed on the outside of the 1-1 and 1-2 light-emitting elements LD1-1 and LD1-2. However, the present application is not limited thereto. Further, the first and second common electrodes 51a and 51b may be formed of the same material as the first and second pixel electrodes 55a and 55b.

The first and second common electrodes 51a and 51b may electrically connect the respective second electrodes 91a and 91b of the 1-1 and 1-2 light-emitting elements LD1-1 and LD1-2 to the common power line 15. Depending on the case, the first and second common electrodes 51a and 51b may be defined as cathodes. The first and second common electrodes 51a and 51b may be disposed along the upper, side, and bottom surfaces of the fourth insulating layer 50, and along the side and upper surfaces of the fifth insulating layer 60.

For example, the first common electrode 51a may overlap the second electrode 91a exposed between the fourth insulating layer 50 and the fifth insulating layer 60. For example, the second common electrode 51b may overlap the second electrode 91b exposed between the fourth insulating layer 50 and the fifth insulating layer 60.

One side of the second common electrode 51b according to one embodiment may be electrically connected to the common power line 15 through a contact hole provided through the first to fourth insulating layers 20, 30, 40, and 50. One side of the first common electrode 51a according to one embodiment may be electrically connected to the second electrode 91a of the 1-1 light-emitting element LD1-1, and the other side of the second common electrode 51b may be electrically connected to the second electrode 91b of the 1-2 light-emitting element LD1-2. Accordingly, the second electrodes 91a and 91b of the 1-1 and 1-2 light-emitting elements LD1-1 and LD1-2 may be electrically connected to the common power line 15 through the first and second common electrodes 51a and 51b, respectively.

The first and second pixel electrodes 55a and 55b and the first and second common electrodes 51a and 51b according to one embodiment may be simultaneously formed through a deposition process for depositing an electrode material and an electrode patterning process that uses a photolithography process and an etching process. Accordingly, in the display panel according to the embodiment, the first and second pixel electrodes 55a and 55b and the first and second common electrodes 51a and 51b, which connect the light-emitting element LD to a pixel driving circuit PD, may be formed simultaneously. Further, the display panel according to the embodiment may allow an electrode connection process to be simplified. In addition, the display panel according to the embodiment may allow a process time for connecting the light-emitting element LD to the pixel driving circuit PD to be significantly reduced, thereby improving the productivity of the display panel.

The sixth insulating layer 70 may be disposed on the substrate 10 on which the first and second pixel electrodes 55a and 55b and the first and second common electrodes 51a and 51b are formed. The sixth insulating layer 70 may be disposed around the pair of light-emitting elements LD1-1 and LD1-2. For example, as shown in FIG. 4, the sixth insulating layer 70 may be in contact with upper surfaces of the first and second pixel electrodes 55a and 55b and the first and second common electrodes 51a and 51b in some areas. For example, as shown in FIG. 5, the sixth insulating layer 70 may be in contact with ends of the first and second pixel electrodes 55a and 55b and the first and second common electrodes 51a and 51b in some areas. However, the display panel of the present application is not limited thereto.

The sixth insulating layer 70 may overlap the fifth insulating layer 60 partially disposed on the fourth insulating layer 50. Therefore, the sixth insulating layer 70 disposed on the protruding fifth insulating layer 60 may prevent color mixing between adjacent sub-pixel units SP.

For example, the sixth insulating layer 70 may be formed of a material including a black pigment. For example, the sixth insulating layer 70 may be formed of an inorganic material such as silicon oxide (SiOx) or silicon nitride (SiNx) or may be formed of an organic material such as benzocyclobutene or photo acryl. The sixth insulating layer 70 may be omitted.

However, the application is not limited thereto.

A transparent buffer layer 80 may be disposed on the sixth insulating layer 70. The transparent buffer layer 80 may be disposed on the substrate 10, on which the sixth insulating layer 70 is formed to provide a flat surface. The transparent buffer layer 80 may cover at least the entire display area AA of the substrate 10. The transparent buffer layer 80 may protect the light-emitting element LD and circuits formed on the substrate 10 from external impacts. For example, the transparent buffer layer 80 may include an optical clear adhesive (OCA) or an optical clear resin (OCR), but the present application is not limited thereto.

Hereinafter, descriptions of configurations identical to those of the display panel according to the first embodiment will be omitted in the following embodiments.

FIG. 6 is a first modified example of the display panel of the first embodiment of the application. FIG. 6 is a schematic plan view of one pixel P among the plurality of pixels P.

Referring to FIG. 6 in conjunction with FIG. 2, the display panel according to the first modified example of the first embodiment of the application may include a plurality of first intaglio patterns IP1 in a plurality of first pattern areas IA1 (see FIG. 2), and may include a plurality of second intaglio patterns IP2 in a second pattern area IA2. Here, a sub-pixel unit SP including a pair of first and second light-emitting elements LD1 and LD2 may be included in each of the first intaglio patterns IP1.

The plurality of first intaglio patterns IP1 according to the embodiment may be disposed to be spaced apart from each other in the X-axis direction. A distance between the first intaglio patterns IP1 may be set to a predetermined distance to prevent cluster defects during a first stamping process. For example, the distance between the first intaglio patterns IP1 may be set to a 2-chip pitch or more.

Each first intaglio pattern IP1 may be formed to have a greater length in the Y-axis direction than in the X-axis direction so that the pair of first and second light-emitting elements LD1 and LD2 are arranged inside the first intaglio pattern IP1 in the Y-axis direction. In addition, each first intaglio pattern IP1 may be provided in a size such that the pair of first and second light-emitting elements LD1 and LD2 may be spaced apart by a predetermined first distance D1.

The plurality of second intaglio patterns IP2 according to the embodiment may each be disposed to correspond to one first intaglio pattern IP1. one second intaglio pattern IP2 may be disposed on one side of each of the plurality of first intaglio patterns IP1 in the Y-axis direction. In addition, in a twice stamping method, each second intaglio pattern IP2 may be spaced at least a predetermined second distance D2 apart from the corresponding first intaglio pattern IP1 in the Y-axis direction to prevent cluster defects during the first stamping process. For example, the second distance D2 may be less than or equal to 1/2 of the second pitch SPP.

The second intaglio pattern IP2 may be an area in which one of the pair of first and second light-emitting elements LD1 and LD2 is temporarily transferred during the first stamping process. Accordingly, the second intaglio pattern IP2 may have an area corresponding to at least one light-emitting element.

Each sub-pixel unit SP according to the embodiment may be included within each of the first intaglio patterns IP1. Each sub-pixel unit SP may include a pair of first and second light-emitting elements LD1 and LD2. The pair of first and second light-emitting elements LD1 and LD2 may be disposed side by side in the Y-axis direction.

The pair of first and second light-emitting elements LD1 and LD2 may be disposed such that their light-emitting areas face each other. Here, the light-emitting area may include an area in which a first electrode E1 of each of the pair of first and second light-emitting elements LD1 and LD2 is located. Accordingly, in the display panel of the application, by arranging the light-emitting areas of the pair of first and second light-emitting elements LD1 and LD2 adjacent to each other, the dispersion of color wavelengths can be stabilized.

Each of the first and second light-emitting elements LD1 and LD2 may include the first electrode E1 and a second electrode E2. Here, the first electrode E1 is an area overlapping an active layer of the light-emitting element and may overlap most of the light-emitting area. Accordingly, in the display panel of the present application, by arranging the first electrodes E1 to face each other, the dispersion of color wavelengths may be stabilized.

The first and second light-emitting elements LD1 and LD2 may be spaced the first distance D1 apart. The first distance D1 of the display panel according to the present application may be smaller than the binocular resolution. For example, the first distance D1 may be set to be less than or equal to 1/2 of a first pitch PP and preferably be less than or equal to 1/10 of the first pitch PP.

In the display panel of the present application, the pair of first and second light-emitting elements LD1 and LD2 may be transferred through the twice stamping method, thereby allowing the first distance D1 to be configured to be smaller than the minimum perceptible pixel interval at the viewing distance. Accordingly, the display panel of the present application may have the effect of preventing a viewer from perceiving stains caused by defects, even when the defects continuously occur in the sub-pixels of each sub-pixel unit. When adopting the twice stamping method, the productivity for transferring the pair of first and second light-emitting elements LD1 and LD2, which are disposed in different directions, may be improved.

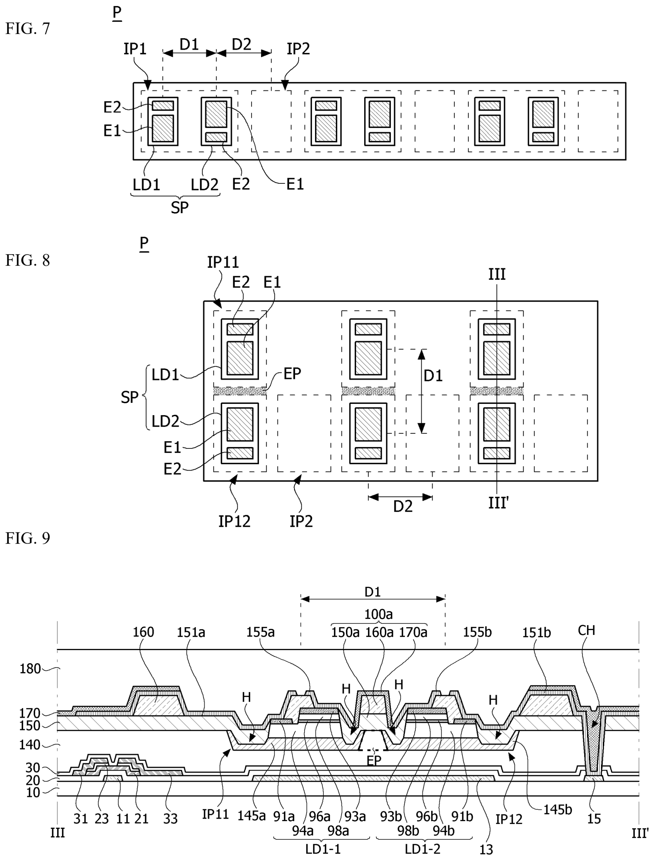

FIG. 7 is a second modified example of the display panel according to the first embodiment of the application. FIG. 7 is a schematic plan view of one pixel P among the plurality of pixels P.

Referring to FIG. 7 in conjunction with FIG. 2, the display panel according to the second modified example of the first embodiment of the application may include a plurality of first intaglio patterns IP1 in a plurality of first pattern areas IA1 (see FIG. 2), and may include a plurality of second intaglio patterns IP2 in a second pattern area IA2 (see FIG. 2). A sub-pixel unit SP including a pair of first and second light-emitting elements LD1 and LD2 may be included in each of the first intaglio patterns IP1.

The plurality of first intaglio patterns IP1 according to the embodiment may be disposed to be spaced apart from each other in the X-axis direction. One second intaglio pattern IP2 may be disposed between the plurality of first intaglio patterns IP1 that are spaced apart from each other.

Each first intaglio pattern IP1 may be formed to have a greater length in the X-axis direction than in the Y-axis direction so that the pair of first and second light-emitting elements LD1 and LD2 are arranged inside the first intaglio pattern IP1 in the X-axis direction. Each first intaglio pattern IP1 may be provided in a size such that the pair of first and second light-emitting elements LD1 and LD2 may be spaced a predetermined first distance D1 apart.

The plurality of second intaglio patterns IP2 according to the present embodiment may each be disposed to correspond to each first intaglio pattern IP1. Each second intaglio pattern IP2 may be disposed on one side of each of the first intaglio patterns IP1 in the X-axis direction. In a twice stamping method, each second intaglio pattern IP2 may be spaced a predetermined second distance D2 apart from the corresponding first intaglio pattern IP1 in the X-axis direction to prevent cluster defects during a first stamping process. For example, the second distance D2 may be less than or equal to 1/2 of the second pitch SPP.

The second intaglio pattern IP2 may be an area in which one of the pair of first and second light-emitting elements LD1 and LD2 is temporarily transferred during the first stamping process. Accordingly, the second intaglio pattern IP2 may have an area corresponding to at least one light-emitting element.

The sub-pixel unit SP according to the present embodiment may include a pair of first and second light-emitting elements LD1 and LD2. The pair of first and second light-emitting elements LD1 and LD2 may be disposed side by side in the X-axis direction. The pair of first and second light-emitting elements LD1 and LD2 may be disposed such that their light-emitting areas are oriented in opposite directions with respect to the Y-axis direction. Accordingly, in the display panel of the present application, by arranging the light-emitting areas of the pair of first and second light-emitting elements LD1 and LD2 adjacent to each other with respect to the X=Y axis direction (diagonal direction), the dispersion of color wavelengths may be stabilized.

Each of the first and second light-emitting elements LD1 and LD2 may include a first electrode E1 and a second electrode E2. The first electrode E1 is an area overlapping an active layer of the light-emitting element and may overlap most of the light-emitting area.

The first and second light-emitting elements LD1 and LD2 may be spaced the first distance D1 apart. The first distance D1 of the display panel according to the present application may be smaller than the binocular resolution. For example, the first distance D1 may be set to be less than or equal to 1/2 of a first pitch PP and preferably be less than or equal to 1/10 of the first pitch PP.

In the display panel of the application, the pair of first and second light-emitting elements LD1 and LD2 may be transferred through the twice stamping method, thereby allowing the first distance D1 to be configured to be smaller than the minimum perceptible pixel interval at the viewing distance. Accordingly, the display panel of the application may have the effect of preventing a viewer from perceiving stains caused by defects, even when the defects continuously occur in the sub-pixels of each sub-pixel unit. When adopting the twice stamping method, the productivity for transferring the pair of first and second light-emitting elements LD1 and LD2, which are disposed in different directions, may be improved.

FIG. 8 is a plan view of a display panel according to a second embodiment of the application, and FIG. 9 is a cross-sectional view taken along line III-III' of FIG. 8. FIG. 8 is a schematic plan view of one pixel P among a plurality of pixels P.

Referring to FIGS. 8 and 9, the display panel according to the embodiment of the present application may include 1-1 and 1-2 intaglio patterns IP11 and IP12 on a third insulating layer 140, a first adhesive layer 145a and 145b and a second adhesive layer (not shown) on the third insulating layer 140, a fourth insulating layer 150 covering the first adhesive layer 145a and 145b and the second adhesive layer (not shown) and exposing first and second light-emitting elements LD1 and LD2, a fifth insulating layer 160 disposed on a portion of the fourth insulating layer 150, first and second pixel electrodes 155a and 155b in contact with first electrodes 93a and 93b of the first and second light-emitting elements LD1 and LD2, first and second common electrodes 151a and 151b in contact with second electrodes 91a and 91b, a sixth insulating layer 170 disposed around the light-emitting elements LD1 and LD2, and a transparent buffer layer 180 configured to planarize an uneven surface on a substrate 10.

Referring to FIGS. 8 and 9 in conjunction with FIG. 2, the display panel according to the second embodiment of the application may include a 1-1 intaglio pattern IP11, a 1-2 intaglio pattern IP12, and a protruding pattern EP in each of a plurality of first pattern areas IA1-1, IA1-2, and IA1-3 (see FIG. 2), and may include a plurality of second intaglio patterns IP2 in a second pattern area IA2 (see FIG. 2).

The plurality of first pattern areas each including the 1-1 intaglio pattern IP11, the 1-2 intaglio pattern IP12, and the protruding pattern EP may be disposed to be spaced apart from each other in the X-axis direction. In addition, the second intaglio pattern IP2 may be disposed in the second pattern area between the first pattern areas.

The 1-1 and 1-2 intaglio patterns IP11 and IP12 may be disposed to be spaced apart from each other in the Y-axis direction. A first light-emitting element LD1 may be disposed inside the 1-1 intaglio pattern IP11, and a second light-emitting element LD2 may be disposed inside the 1-2 intaglio pattern IP12. The 1-1 and 1-2 intaglio patterns IP11 and IP12 may each be provided in a size corresponding to at least an area of the light-emitting element. For example, when the light-emitting element has a greater length in the Y-axis direction than in the X-axis direction, each of the 1-1 and 1-2 intaglio patterns IP11 and IP12 may be formed to have a greater length in the Y-axis direction than in the X-axis direction.

The protruding pattern EP may be disposed between the 1-1 and 1-2 intaglio patterns IP11 and IP12. The protruding pattern EP may be formed along a length in an X-axis direction of each of the 1-1 and 1-2 intaglio patterns IP11 and IP12. The protruding pattern EP may be integrally formed with the third insulating layer 140. The protruding pattern EP may be formed together with the 1-1 and 1-2 intaglio patterns IP11 and IP12 when forming the 1-1 and 1-2 intaglio patterns IP11 and IP12 of the third insulating layer 140.

Referring to FIG. 9, the protruding pattern EP may have a shape protruding in the Z-axis direction (away from the substrate 10) from bottom surfaces of the 1-1 and 1-2 intaglio patterns IP11 and IP12. The protruding pattern EP may include a side surface of each of the adjacent 1-1 and 1-2 intaglio patterns IP11 and IP12. The protruding pattern EP may partially overlap the 1-1 and 1-2 intaglio patterns IP11 and IP12.

The protruding pattern EP may prevent interference between two light-emitting elements during a process of transferring the light-emitting elements onto the 1-1 and 1-2 intaglio patterns IP11 and IP12. The 1-1 and 1-2 intaglio patterns IP11 and IP12 may guide the positions of the plurality of light-emitting elements LD in the transfer process of transferring the plurality of light-emitting elements LD to a display panel 1.

As the protruding pattern EP is formed, the present embodiment may further include a protrusion 100a on the protruding pattern EP. The protrusion 100a may include a first protrusion 150a of the fourth insulating layer 150, a second protrusion 160a of the fifth insulating layer 160, and a third protrusion 170a of the sixth insulating layer 170. The first to third protrusions 150a, 160a, and 170a may be naturally formed when forming the insulating layers of the corresponding layers due to the protruding shape of the protruding pattern EP. The first to third protrusions 150a, 160a, and 170a may not be formed in some cases or may be selectively formed.

As the protruding pattern EP is formed, the first adhesive layer may be disposed in each of the 1-1 and 1-2 intaglio patterns IP11 and IP12. Accordingly, the first adhesive layer of the present embodiment may include the first adhesive layer 145a disposed in the 1-1 intaglio pattern IP11 and the first adhesive layer 145b disposed in the 1-2 intaglio pattern IP12. The plurality of second intaglio patterns IP2 according to the present embodiment may be disposed to correspond to one of the 1-1 and 1-2 intaglio patterns IP11 and IP12. Each second intaglio pattern IP2 may be disposed on one side of the 1-1 or 1-2 intaglio pattern IP11 or IP12 in the X-axis direction. In addition, in a twice stamping method, each second intaglio pattern IP2 may be spaced a predetermined second distance D2 apart from the corresponding 1-1 or 1-2 intaglio pattern IP11 or IP12 in the X-axis direction to prevent cluster defects during a first stamping process. For example, the second distance D2 may be formed to be less than or equal to 1/2 of a second pitch SPP.

The second intaglio pattern IP2 may be an area in which one of the pair of first and second light-emitting elements LD1 and LD2 is temporarily transferred during the first stamping process. Accordingly, the second intaglio pattern IP2 may have an area corresponding to at least one light-emitting element.

The first light-emitting element LD1 may be disposed on the 1-1 intaglio pattern IP11, and the second light-emitting element LD2 may be disposed on the 1-2 intaglio pattern IP12. The pair of first and second light-emitting elements LD1 and LD2 may constitute a sub-pixel unit SP. The pair of first and second light-emitting elements LD1 and LD2 may be disposed such that their first electrodes EI face each other. The first electrode E1 of the light-emitting element is an area overlapping an active layer of the light-emitting element and may overlap most of the light-emitting area. Accordingly, the display panel of the present application may have a uniform dispersion of color wavelengths.

The first and second light-emitting elements LD1 and LD2 may be spaced a first distance D1 apart. The first distance D1 of the display panel according to the present application may be smaller than the binocular resolution. For example, the first distance D1 may be set to be less than or equal to 1/2 of a first pitch PP and preferably be less than or equal to 1/10 of the first pitch PP. Accordingly, the display panel of the present application may have the effect of preventing a viewer from perceiving stains caused by defects, even when the defects continuously occur in the sub-pixels of each sub-pixel unit. Further, by adopting the twice stamping method, the productivity for transferring the pair of first and second light-emitting elements LD1 and LD2, which are disposed in different directions, may be improved.

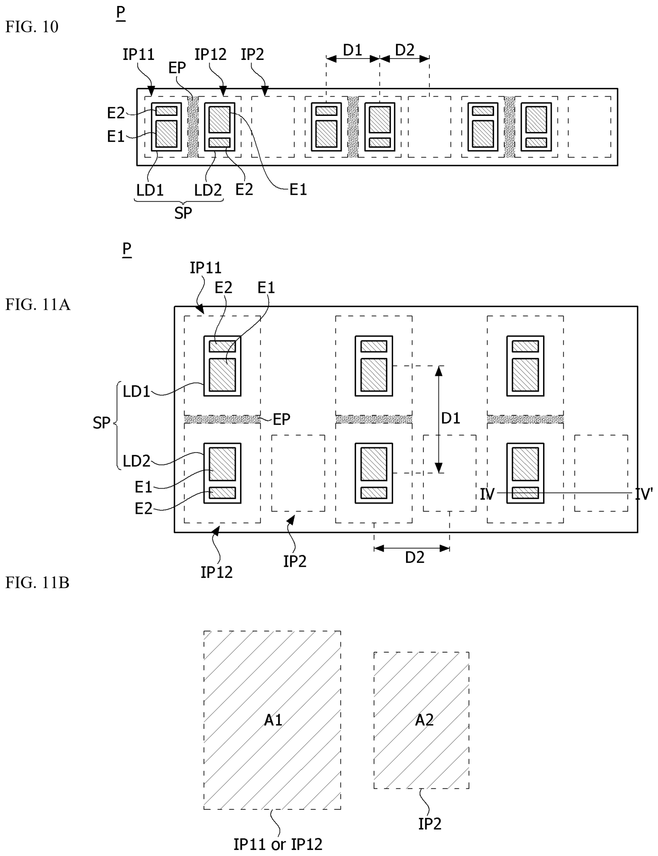

FIG. 10 is a first modified example of the display panel according to the second embodiment of the present application. FIG. 10 is a schematic plan view of one pixel P among the plurality of pixels P.

Referring to FIG. 10 in conjunction with FIG. 2, the display panel according to the first modified example of the second embodiment of the present application may include a 1-1 intaglio pattern IP11, a 1-2 intaglio pattern IP12, and a protruding pattern EP in each of a plurality of first pattern areas IA1-1, IA1-2, and IA1-3 (see FIG. 2), and may include a plurality of second intaglio patterns IP2 in a second pattern area IA2 (see FIG. 2).

The plurality of first pattern areas each including the 1-1 intaglio pattern IP11, the 1-2 intaglio pattern IP12, and the protruding pattern EP may be disposed to be spaced apart from each other in the X-axis direction. The second intaglio pattern IP2 may be disposed in the second pattern area between the first pattern areas.

The 1-1 and 1-2 intaglio patterns IP11 and IP12 may be disposed to be spaced apart from each other in the X-axis direction. A first light-emitting element LD1 may be disposed inside the 1-1 intaglio pattern IP11. A second light-emitting element LD2 may be disposed inside the 1-2 intaglio pattern IP12.

The 1-1 and 1-2 intaglio patterns IP11 and IP12 may each be provided in a size corresponding to at least an area of the light-emitting element. For example, when the light-emitting element has a greater length in the Y-axis direction than in the X-axis direction, each of the 1-1 and 1-2 intaglio patterns IP11 and IP12 may be formed to have a greater length in the Y-axis direction than in the X-axis direction.

The protruding pattern EP may be disposed between the 1-1 and 1-2 intaglio patterns IP11 and IP12. The protruding pattern EP may be formed along a length in a Y-axis direction of each of the 1-1 and 1-2 intaglio patterns IP11 and IP12. The protruding pattern EP may be integrally formed with the third insulating layer 140 (see FIG. 9). The protruding pattern EP is not limited to what is shown in FIG. 10, and may partially overlap adjacent side surfaces of the 1-1 and 1-2 intaglio patterns IP11 and IP12.

The plurality of second intaglio patterns IP2 according to the present embodiment may be disposed to correspond to the 1-1 and 1-2 intaglio patterns IP11 and IP12. Each second intaglio pattern IP2 may be disposed on one side of the 1-1 or 1-2 intaglio pattern IP11 or IP12 in the X-axis direction. In a twice stamping method, each second intaglio pattern IP2 may be spaced a predetermined second distance D2 apart from the corresponding 1-1 or 1-2 intaglio pattern IP11 or IP12 in the X-axis direction to prevent cluster defects during a first stamping process. For example, the second distance D2 may be less than or equal to 1/2 of the second pitch SPP.

The second intaglio pattern IP2 may be an area in which one of the pair of first and second light-emitting elements LD1 and LD2 is temporarily transferred during the first stamping process. Accordingly, the second intaglio pattern IP2 may have an area corresponding to at least one light-emitting element.

The first light-emitting element LD1 may be disposed on the 1-1 intaglio pattern IP11, and the second light-emitting element LD2 may be disposed on the 1-2 intaglio pattern IP12. The pair of first and second light-emitting elements LD1 and LD2 may constitute a sub-pixel unit SP. In this case, the pair of first and second light-emitting elements LD1 and LD2 may be disposed such that their light-emitting areas are oriented in opposite directions with respect to the Y-axis direction. Accordingly, in the display panel of the present application, by arranging the light-emitting areas of the pair of first and second light-emitting elements LD1 and LD2 adjacent to each other with respect to the X=Y axis direction, the dispersion of color wavelengths may be stabilized.

The first and second light-emitting elements LD1 and LD2 may be spaced a first distance D1 apart. The first distance D1 of the display panel according to the present application may be smaller than the binocular resolution. For example, the first distance D1 may be set to be less than or equal to 1/2 of a first pitch PP and preferably be less than or equal to 1/10 of the first pitch PP. Accordingly, the display panel of the present application may have the effect of preventing a viewer from perceiving stains caused by defects, even when the defects continuously occur in the sub-pixels of each sub-pixel unit. Further, by adopting the twice stamping method, the productivity for transferring the pair of first and second light-emitting elements LD1 and LD2, which are disposed in different directions, may be improved.

FIG. 11A is a plan view of a display panel according to a third embodiment of the present application, and FIG. 11B is a plan view illustrating a comparison between first and second intaglio patterns of FIG. 11A. FIG. 12 is a cross-sectional view taken along line IV-IV' of FIG. 11A. Here,

FIG. 11A is a schematic plan view of one pixel P among a plurality of pixels P.

Referring to FIGS. 11A to 12, the display panel according to the present embodiment of the present application may include 1-1 and 1-2 intaglio patterns IP11 and IP12 on a third insulating layer 240, first and second adhesive layers 245 and 247 on the third insulating layer 240, a fourth insulating layer 250 covering the first and second adhesive layers 245 and 247 and exposing first and second light-emitting elements LD1 and LD2, a fifth insulating layer 260 disposed on a portion of the fourth insulating layer 250, a common electrode 251b in contact with a second electrode 91b of the second light-emitting element LD2, a sixth insulating layer 270 disposed around the first and second light-emitting elements LD1 and LD2, and a transparent buffer layer 280 configured to planarize an uneven surface on a substrate 10.

Referring to FIG. 11A in conjunction with FIG. 2, the display panel according to the third embodiment of the present application may include a 1-1 intaglio pattern IP11, a 1-2 intaglio pattern IP12, and a protruding pattern EP in each of a plurality of first pattern areas IA1-1, IA1-2, and IA1-3 (see FIG. 2), and may include a plurality of second intaglio patterns IP2 in a second pattern area IA2 (see FIG. 2).

Referring to FIGS. 11A and 11B, in the display panel according to the present embodiment, a first area A1 of each of the 1-1 and 1-2 intaglio patterns IP11 and IP12 may be larger than a second area A2 of the second intaglio pattern IP2. Referring to FIG. 12, a first length A1-a of each of the 1-1 and 1-2 intaglio patterns IP11 and IP12 in the X-axis direction may be greater than a second length A2-a of the second intaglio pattern IP2 in the X-axis direction.

The 1-1 and 1-2 intaglio patterns IP11 and IP12 may be areas in which the first and second light-emitting elements LD1 and LD2 are transferred and adhered during a stamping process. In contrast, the second intaglio pattern IP2 may be a non-transfer area in which one of the pair of first and second light-emitting elements LD1 and LD2 is temporarily seated after being transferred during the stamping process but ultimately is not transferred.

Since each of the 1-1 and 1-2 intaglio patterns IP11 and IP12 is formed sufficiently larger than the area of each of the first and second light-emitting elements LD1 and LD2, a relatively strong pressure may be applied. Being formed larger than the area of each of the first and second light-emitting elements LD1 and LD2 may mean that each of the 1-1 and 1-2 intaglio patterns IP11 and IP12 is formed larger than the second intaglio pattern IP2. The application of relatively strong pressure may mean that a greater pressure is applied to the 1-1 and 1-2 intaglio patterns IP11 and IP12 than to the second intaglio pattern IP2. Accordingly, even when the adhesive layer is substantially unevenly formed on the 1-1 and 1-2 intaglio patterns IP11 and IP12 or a pressure difference occurs in a donor, the light-emitting elements are transferred with a relatively strong force, thereby reducing a defect rate of non-transferred light-emitting elements.

FIG. 13 is a plan view of a part of a display panel according to a fourth embodiment of the present application. FIG. 13 is a schematic plan view of one pixel P among a plurality of pixels P.

Referring to FIG. 13 in conjunction with FIG. 2, the display panel according to the fourth embodiment of the present application may include a first intaglio pattern IP1 in each of a plurality of first pattern areas IA1-1, IA1-2, and IA1-3 (see FIG. 2), and may include a plurality of second intaglio patterns IP2 and a plurality of first dummy intaglio patterns DP1 in a second pattern area IA2 (see FIG. 2). For example, the first dummy intaglio patterns DP1 may be formed in the same manner as the second intaglio patterns IP2.

The second intaglio pattern IP2 and the first dummy intaglio pattern DP1 may be disposed on one side of each of the first intaglio patterns IP1. The second intaglio pattern IP2 and the first dummy intaglio pattern DP1 may be disposed to correspond to each pair of first and second light-emitting elements LD1 and LD2 disposed in the first intaglio patterns IP1. As shown in FIG. 13, when the pair of first and second light-emitting elements LD1 and LD2 are disposed side by side in the Y-axis direction, the second intaglio pattern IP2 and the first dummy intaglio pattern DP1 may also be disposed side by side in the Y-axis direction.

For example, the first dummy intaglio pattern DP1 may be disposed to correspond to one side of a first light-emitting element LD1, and the second intaglio pattern IP2 may be disposed to correspond to one side of a second light-emitting element LD2. The display panel according to the present embodiment may further include the first dummy intaglio pattern DP1, which has a configuration disposed to correspond to the light-emitting element, in comparison with the previous embodiments. Accordingly, the display panel according to the present embodiment may have an improved degree of freedom in a transfer direction. In addition, the first dummy intaglio pattern DP1 may further accommodate an adhesive layer, thereby allowing the adhesive layer within the intaglio patterns to be formed with a more uniform thickness.

FIG. 14 is a first modified example of the display panel according to the fourth embodiment of the present application. FIG. 14 is a schematic plan view of one pixel P among the plurality of pixels P.

Referring to FIG. 14 in conjunction with FIG. 2, the display panel according to the first modified example of the fourth embodiment of the present application may include a first intaglio pattern IP1 in each of a plurality of first pattern areas IA1-1, IA1-2, and IA1-3 (see FIG. 2), and may include a plurality of second intaglio patterns IP2 and a plurality of first dummy intaglio patterns DP1 in a second pattern area IA2 (see FIG. 2).

The second intaglio pattern IP2 and the first dummy intaglio pattern DP1 may be disposed on one side of each of the first intaglio patterns IP1. The first dummy patterns DP1 may be further disposed in an area, in which the second intaglio pattern IP2 is not disposed, on the other side of the first intaglio pattern IP1 located at an edge of the pixel P.

For example, the first dummy intaglio pattern DP1 and the second intaglio pattern IP2 may be disposed side by side in the Y-axis direction on one side of each of the first intaglio patterns IP1 disposed in first, second, and third columns. In addition, two first dummy intaglio patterns DP1 may be disposed side by side in the Y-axis direction on the other side of the first intaglio pattern IP1 disposed in the first column.

The display panel according to the present embodiment may further include the first dummy intaglio patterns DP1, thereby further improving the degree of freedom in the transfer direction. In addition, the first dummy intaglio pattern DP1 may further accommodate an adhesive layer, thereby allowing the adhesive layer within the intaglio patterns to be formed with a more uniform thickness.

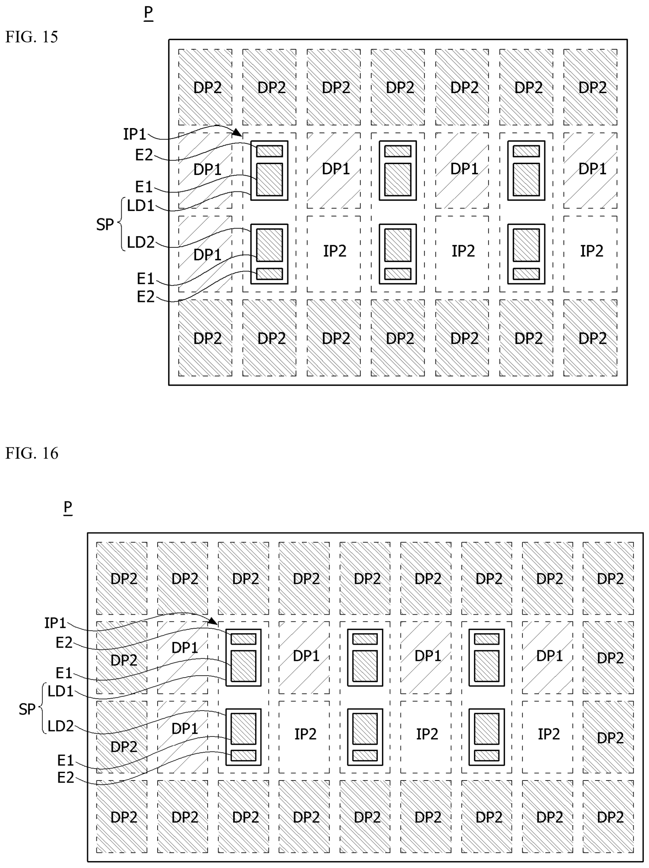

FIG. 15 is a plan view of a part of a display panel according to a fifth embodiment of the present application. FIG. 15 is a schematic plan view of one pixel P among a plurality of pixels P.

Referring to FIG. 15 in conjunction with FIG. 2, the display panel according to the fifth embodiment of the present application may include a first intaglio pattern IP1 in each of a plurality of first pattern areas IA1-1, IA1-2, and IA1-3 (see FIG. 2) and may include a plurality of second intaglio patterns IP2, a plurality of first dummy intaglio patterns DP1, and a plurality of second dummy intaglio patterns DP2 in a second pattern area IA2 (see FIG. 2).

The second intaglio pattern IP2 and the first dummy intaglio pattern DP1 may be disposed on one side of each of the first intaglio patterns IP1. The first dummy patterns DP1 may be further disposed in an area, in which the second intaglio pattern IP2 is not disposed, on the other side of the first intaglio pattern IP1 located at an edge of the pixel P.

The second dummy intaglio patterns DP2 may be disposed in the Y-axis direction respectively corresponding to the plurality of first intaglio patterns IP1, the plurality of second intaglio patterns IP2, and the plurality of first dummy intaglio patterns DP1. The first dummy intaglio patterns DP1 and the second dummy intaglio patterns DP2 may have an arrangement structure that surrounds the first intaglio patterns IP1.

For example, seven second dummy intaglio patterns DP2 may be disposed side by side in a first row. For example, in a second row, the first dummy intaglio pattern DP1, the first intaglio pattern IP1, the first dummy intaglio pattern DP1, the first intaglio pattern IP1, the first dummy intaglio pattern DP1, the first intaglio pattern IP1, and the first dummy intaglio pattern DP1 may be sequentially disposed from the left, respectively corresponding to the seven second dummy intaglio patterns DP2.

For example, in a third row, the first dummy intaglio pattern DP1, the first intaglio pattern IP1, the second intaglio pattern IP2, the first intaglio pattern IP1, the second intaglio pattern IP2, the first intaglio pattern IP1, and the second intaglio pattern IP2 may be sequentially disposed from the left, respectively corresponding to the seven second dummy intaglio patterns DP2. For example, in a fourth row, seven second dummy intaglio patterns DP2 may be disposed respectively corresponding to the seven second dummy intaglio patterns DP2.

The display panel according to the present embodiment, in comparison with the previous embodiments, may have the effect of improving the degree of freedom in a transfer direction and improving the uniformity of a thickness of the adhesive layer by further including the second dummy intaglio patterns DP2.

FIG. 16 is a first modified example of the display panel according to the fifth embodiment of the present application. FIG. 16 is a schematic plan view of one pixel P among the plurality of pixels P.

Referring to FIG. 16 in conjunction with FIG. 2, the display panel according to the first modified example of the fifth embodiment of the application may include a first intaglio pattern IP1 in each of a plurality of first pattern areas IA1-1, IA1-2, and IA1-3 (see FIG. 2), and may include a plurality of second intaglio patterns IP2, a plurality of first dummy intaglio patterns DP1, and a plurality of second dummy intaglio patterns DP2 in a second pattern area IA2 (see FIG. 2).

The second intaglio pattern IP2 and the first dummy intaglio pattern DP1 may be disposed on one side of each of the first intaglio patterns IP1. In addition, the first dummy patterns DP1 may be further disposed in an area, in which the second intaglio pattern IP2 is not disposed, on the other side of the first intaglio pattern IP1, which is opposite to the one side of the first intaglio pattern IP1 located at an edge of the pixel P.

The second dummy intaglio patterns DP2 may be disposed in both the X-axis and Y-axis directions, respectively corresponding to the plurality of first intaglio patterns IP1, the plurality of second intaglio patterns IP2, and the plurality of first dummy intaglio patterns DP1. That is, the second dummy intaglio patterns DP2 may have an arrangement structure surrounding the plurality of first intaglio patterns IP1, the plurality of second intaglio patterns IP2, and the plurality of first dummy intaglio patterns DP1.

For example, nine second dummy intaglio patterns DP2 may be disposed side by side in a first row. For example, in a second row, the second dummy intaglio pattern DP2, the first dummy intaglio pattern DP1, the first intaglio pattern IP1, the first dummy intaglio pattern DP1, the first intaglio pattern IP1, the first dummy intaglio pattern DP1, the first intaglio pattern IP1, the first dummy intaglio pattern DP1, and the second dummy intaglio pattern DP2 may be sequentially disposed from the left, respectively corresponding to the nine second dummy intaglio patterns DP2. For example, in a third row, the second dummy intaglio pattern DP2, the first dummy intaglio pattern DP1, the first intaglio pattern IP1, the second intaglio pattern IP2, the first intaglio pattern IP1, the second intaglio pattern IP2, the first intaglio pattern IP1, the second intaglio pattern IP2, and the second dummy intaglio pattern DP2 may be sequentially disposed from the left, respectively corresponding to the nine second dummy intaglio patterns DP2. For example, in a fourth row, nine second dummy intaglio patterns DP2 may be disposed respectively corresponding to the nine second dummy intaglio patterns DP2.

The second dummy intaglio patterns DP2 disposed at both ends of the first intaglio pattern IP1 in the X-axis direction may allow the thickness of the adhesive layer within the second intaglio pattern IP2, which is an area in which the light-emitting element is temporarily transferred during a first stamping process, to become uniform. Accordingly, the display panel according to the present application may prevent the light-emitting elements from being over-transferred to the second intaglio pattern IP2 during the first stamping process. Here, the second dummy intaglio patterns DP2 disposed in the X-axis direction with respect to the first intaglio pattern IP1 may refer to the four second dummy intaglio patterns DP2 disposed at both ends of the second and third rows, with reference to FIG. 16.

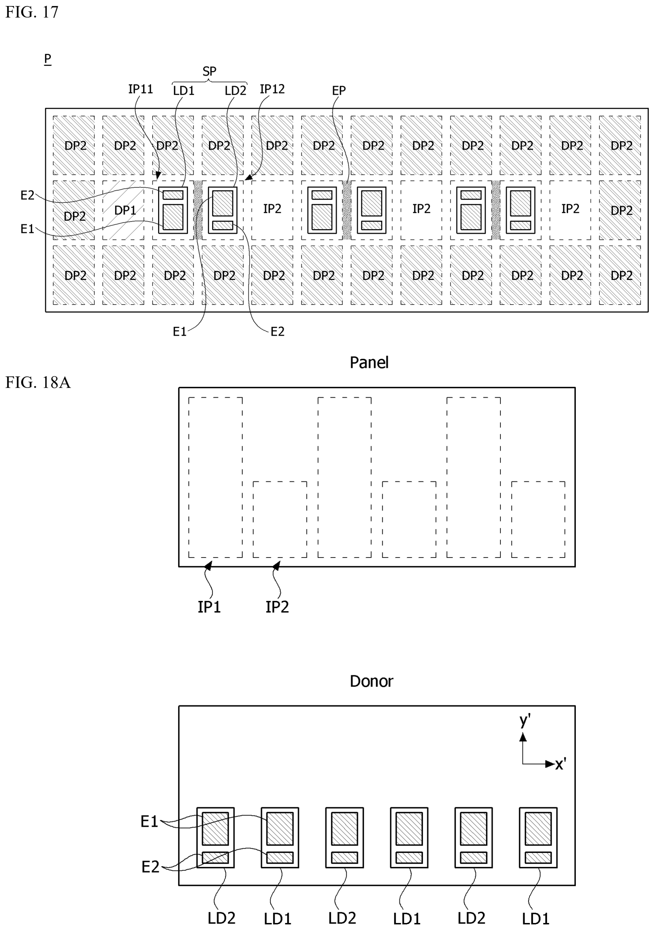

FIG. 17 is a plan view of a part of a display panel according to a sixth embodiment of the present application. FIG. 17 is a schematic plan view of one pixel P among a plurality of pixels P.

Referring to FIG. 17 in conjunction with FIG. 2, the display panel according to the sixth embodiment of the present application may include a 1-1 intaglio pattern IP11, a 1-2 intaglio pattern IP12, and a protruding pattern EP in each of a plurality of first pattern areas IA1-1, IA1-2, and IA1-3 (see FIG. 2), and may include a plurality of second intaglio patterns IP2, a plurality of first dummy intaglio patterns DP1, and a plurality of second dummy intaglio patterns DP2 in a second pattern area IA2 (see FIG. 2).

The present embodiment relates to an arrangement structure of the first dummy intaglio patterns DP1 and the second dummy intaglio patterns DP2 when the plurality of first pattern areas, each including the 1-1 intaglio pattern IP11, the 1-2 intaglio pattern IP12, and the protruding pattern EP, are spaced apart from each other in the X-axis direction.

The second intaglio pattern IP2 may be disposed on one side of each of the 1-1 and 1-2 intaglio patterns IP11 and IP12 along the X-axis direction. The first dummy intaglio pattern DP1 may be disposed on the other side of each of the 1-1 and 1-2 intaglio patterns IP11 and IP12, in which the second intaglio pattern IP2 is not disposed, along the X-axis direction.

The second dummy intaglio patterns DP2 may be disposed in a manner that surrounds the 1-1 and 1-2 intaglio patterns IP11 and IP12, the second intaglio pattern IP2, and the first dummy intaglio pattern DP1.

For example, twelve second dummy intaglio patterns DP2 may be disposed side by side in a first row. For example, in a second row, the second dummy intaglio pattern DP2, the first dummy intaglio pattern DP1, the 1-1 intaglio pattern IP11, the 1-2 intaglio pattern IP12, the second intaglio pattern IP2, the 1-1 intaglio pattern IP11, the 1-2 intaglio pattern IP12, the second intaglio pattern IP2, the 1-1 intaglio pattern IP11, the 1-2 intaglio pattern IP12, the second intaglio pattern IP2, and the second dummy intaglio pattern DP2 may be sequentially disposed from the left, respectively corresponding to the twelve second dummy intaglio patterns DP2. For example, in a third row, twelve second dummy intaglio patterns DP2 may be disposed respectively corresponding to the twelve second dummy intaglio patterns DP2.

Accordingly, the display panel according to the present embodiment may have the effect of improving the degree of freedom in a transfer direction and improving the uniformity of an adhesive layer thickness.

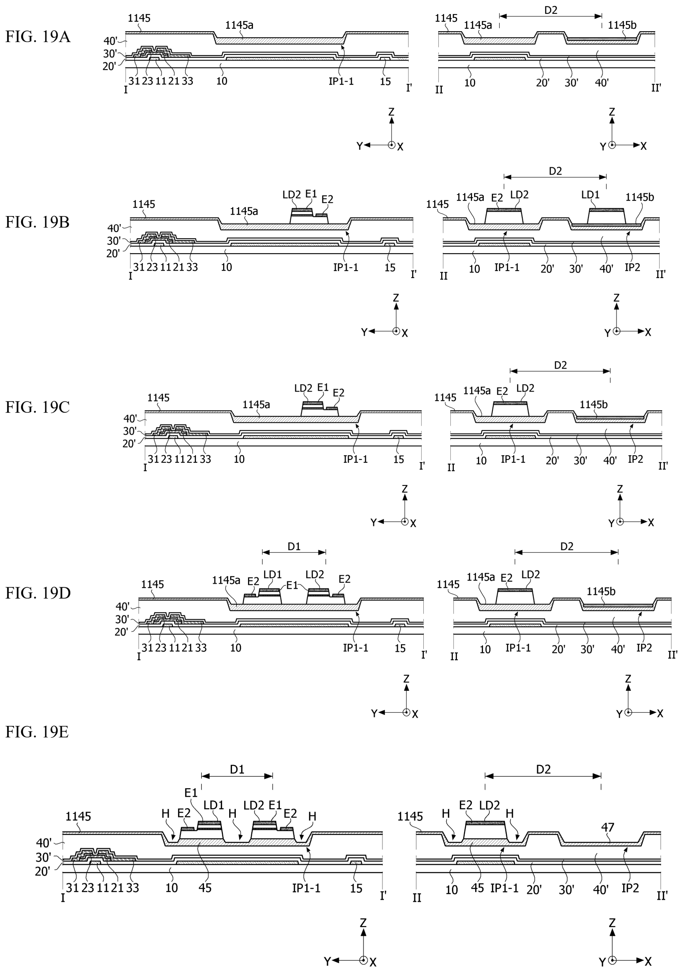

FIGS. 18A to 18E and FIGS. 19A to 19F are process plan views and process cross-sectional views, respectively, according to the first embodiment of the application.

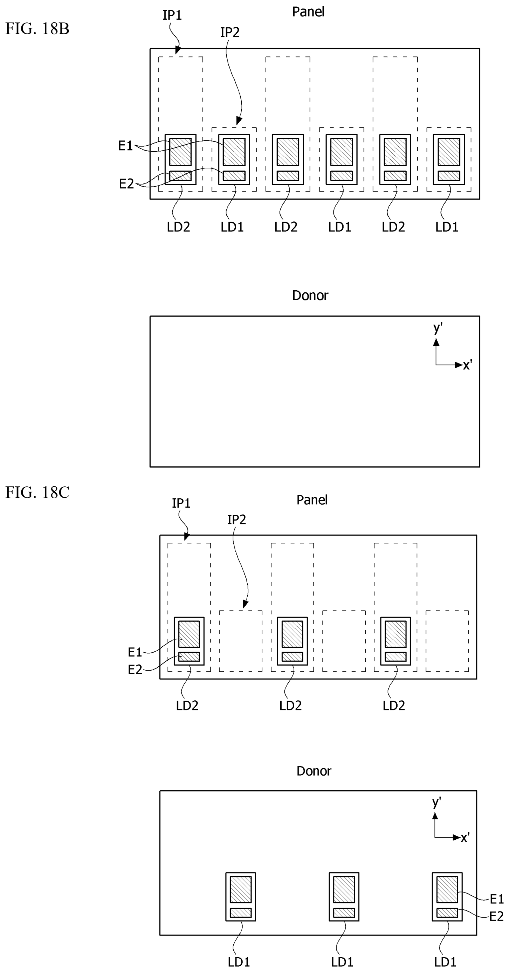

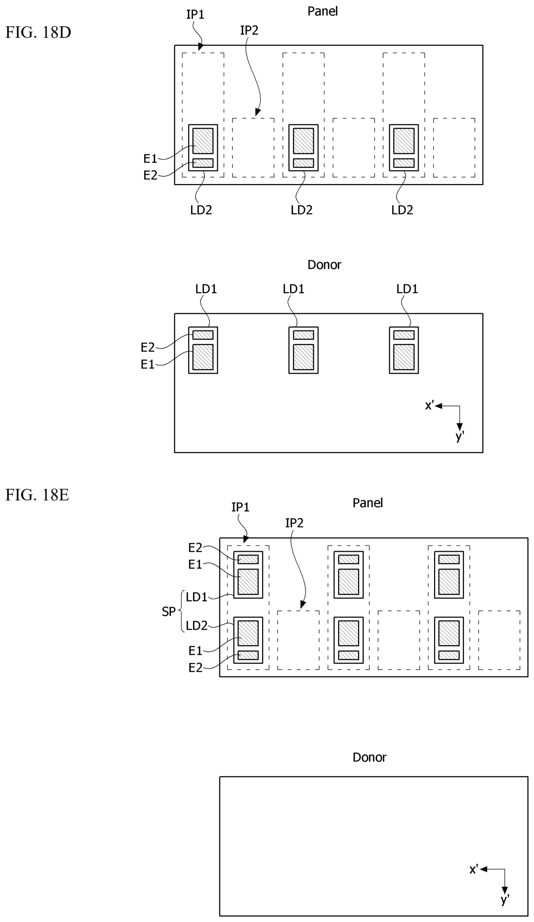

FIG. 18A corresponds to the same process operation (or step) as FIG. 19A, FIG. 18B corresponds to the same process operation as FIG. 19B, FIG. 18C corresponds to the same process operation (or step) as FIG. 19C, and FIG. 18E corresponds to the same process operation (or step) as FIG. 19D.

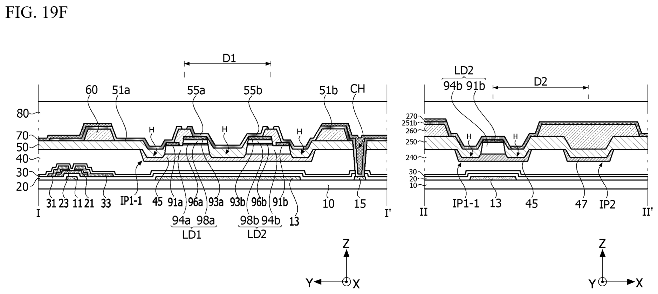

In FIGS. 18A to 18E and FIGS. 19A to 19F, for convenience of description, the 1-1, 1-2, and 1-3 intaglio patterns IP1-1, IP1-2, and IP1-3 shown in FIGS. 3 to 5 are illustrated and described as the first intaglio patterns IP1, the 1-1, 2-1, and 3-1 light-emitting elements LD1-1, LD2-1, and LD3-1 are illustrated and described as the first light-emitting elements LD1, and the 1-2, 2-2, and 3-2 light-emitting elements LD1-2, LD2-2, and LD3-2 are illustrated and described as the second light-emitting elements LD2. First electrodes 93a and 93b of FIG. 19F are the same as first electrodes E1 in FIGS. 18A to 18E, and second electrodes 91a and 91b of FIG. 19F are the same as second electrodes E2 in FIGS. 18A to 18E.

In FIGS. 19A to 19F, a cross-sectional view along line I-I' (on the left side) is a cross-sectional view along the Y-axis direction for a pixel P, and a cross-sectional view along line II-II' (on the right side) is a cross-sectional view along an X-axis direction for the pixel P. In addition, referring to FIGS. 18A to 19F, an XY coordinate system on a panel and an x'y' coordinate system on a donor are considered independent of each other.

Referring to FIGS. 18A and 19A, the first intaglio patterns IP1 and second intaglio patterns IP2 may be alternately disposed in the X-axis direction on a substrate 10 of the panel.

A first adhesive layer 1145 may be disposed entirely on a primary third insulating layer 40'. Since the first adhesive layer 1145 has fluidity, the first adhesive layer 1145 may flow into the first and second intaglio patterns IP1 and IP2, which are at relatively lower positions. Thus, the first adhesive layer 1145 may be formed with a relatively small thickness on an upper portion of the primary third insulating layer 40', except for the first and second intaglio patterns IP1 and IP2.

The first intaglio pattern IP1 may be an area in which the light-emitting elements LD1 and LD2 are transferred and adhered. The second intaglio pattern IP2 may be an area in which the light-emitting elements LD1 and LD2 are temporarily seated, and detached after a first stamping process. A primary second adhesive layer 1145b formed on the second intaglio pattern IP2 may have a lower surface adhesion than a primary first adhesive layer 1145a formed on the first intaglio pattern IP1. To this end, the primary second adhesive layer 1145b may be in a surface-hardened state.

On the donor, a plurality of first light-emitting elements LD1 and a plurality of second light-emitting elements LD2 may be alternately arranged in an x'-axis direction. Each of the second light-emitting elements LD2 on the donor may be disposed to correspond to the first intaglio pattern IP1, and each of the first light-emitting elements LD1 on the donor may be disposed to correspond to the second intaglio pattern IP2. Alternately, each of the first light-emitting elements LD1 on the donor may be disposed to correspond to the first intaglio pattern IP1, and each of the second light-emitting elements LD2 on the donor may be disposed to correspond to the second intaglio pattern IP2.

The first electrode E1 of each of the plurality of first and second light-emitting elements LD1 and LD2 may be aligned in the same direction. That is, a light-emitting area of each of the plurality of first and second light-emitting elements LD1 and LD2 may be aligned in the same direction along an extension line in a longitudinal or width direction of the donor. For example, the light-emitting area of each of the plurality of first and second light-emitting elements LD1 and LD2 may be aligned in a y'-axis direction of the donor.

A primary first insulating layer 20', a primary second insulating layer 30', and the primary third insulating layer 40' may be in a state in which contact holes for exposing a pixel driving circuit PD and a common power line 15 are not formed.

Referring to FIGS. 18B and 19B, the panel and the donor may be aligned, and a first stamping process may be performed. The plurality of first and second light-emitting elements LD1 and LD2 may be transferred from the donor onto the panel. For example, the second light-emitting element LD2 may be transferred onto the primary first adhesive layer 1145a of the first intaglio pattern IP1, and the first light-emitting element LD1 may be seated on the primary second adhesive layer 1145b of the second intaglio pattern IP2.

Referring to FIGS. 18C and 19C, the first light-emitting element LD1 transferred onto the primary second adhesive layer 1145b may be bonded to the donor. This is because the adhesion of the primary second adhesive layer 1145b is relatively low. In the panel, due to the adhesion of the primary first adhesive layer 1145a, the second light-emitting element LD2 may remain transferred onto the primary first adhesive layer 1145a of the first intaglio pattern IP1.

Referring to FIG. 18D, the donor may maintain a parallel state with the panel and rotate 180 degrees in a counterclockwise direction. The positions of the first electrode E1 and the second electrode E2 of each of the first light-emitting elements LD1 on the donor may be reversed.

Referring to FIGS. 18E and 19D, the first light-emitting elements LD1 may be transferred onto the panel. Each first light-emitting element LD1 may be transferred onto the primary first adhesive layer 1145a of the first intaglio pattern IP1 while being spaced a first distance D1 apart from the second light-emitting element LD2.

Referring to FIG. 19E, an etching process may be performed to improve the contact capability of the first and second electrodes 93a, 93b, 91a, and 91b. The first adhesive layer 1145, which was located above the primary third insulating layer 40', except for the first and second intaglio patterns IP1 and IP2, may be removed. An area of the primary first adhesive layer 1145a, which does not overlap the light-emitting elements LD1 and LD2, may be removed using the first and second light-emitting elements LD1 and LD2 as a mask, thereby forming a first adhesive layer 45.

The first adhesive layer 45 may have a groove H formed in the area not overlapping the first and second light-emitting elements LD1 and LD2. The primary second adhesive layer 1145b may be etched to a thickness similar to the first adhesive layer 45, thereby forming a second adhesive layer 47.

Referring to FIG. 19F, a fourth insulating layer 50 and a fifth insulating layer 60 may be formed on the substrate 10 on which the first and second adhesive layers 45 and 47 are formed, and a contact hole CH configured to expose a portion of the common power line 15 and a portion of the pixel driving circuit PD may be formed through first to fourth insulating layers 20, 30, 40, and 50. Next, first and second pixel electrodes 55a and 55b, first and second common electrodes 51a and 51b, a sixth insulating layer 70, and a transparent buffer layer 80 may be sequentially formed on the substrate 10 on which the fifth insulating layer 60 is formed.

As described, the display panel of the application may adopt a twice stamping method for transferring a pair of light-emitting elements LD1 and LD2 disposed (or oriented) in different directions by configuring a second intaglio pattern IP2.

If, for a pair of light-emitting elements including a first light-emitting element and a second light-emitting element, the first light-emitting element disposed in a first direction on a wafer is aligned on a donor and then transferred onto a panel, and the second light-emitting element disposed in a second direction on the wafer is aligned on the donor and then transferred onto the panel, a relatively long time may be required due to the process of aligning from the wafer to the donor.

In the application, by configuring the second intaglio pattern IP2, all light-emitting elements on the wafer may be aligned on the donor at one time, and the pair of light-emitting elements may be disposed in different directions. Accordingly, the display panel of the present application may have improved productivity (capacity drop). In other words, the display panel of the present application may allow an increase in the number of panels that can be produced within a certain period of time.

By adopting the twice stamping method, the display panel of the application may allow the pair of light-emitting elements disposed in different directions to be disposed in close proximity at a first distance, which is smaller than the binocular resolution at the viewing distance, thereby preventing a viewer from perceiving stains caused by defects.

A display panel of the application can prevent a viewer from perceiving stains caused by defects. A display panel of the application can improve productivity in the process of transferring light-emitting elements. A display panel of the application can prevent light-emitting elements from being excessively transferred onto a panel.

The effects of the application are not limited to the effects mentioned above, and other effects not mentioned can be clearly understood by those skilled in the art to which the technical idea of the application pertains from the following description. While the embodiments of the disclosure have been described in detail above with reference to the accompanying drawings, the disclosure is not necessarily limited to these embodiments, and various changes and modifications may be made without departing from the technical concepts of the disclosure. Accordingly, the embodiments disclosed herein are to be considered descriptive and not restrictive of the technical concept of the disclosure, and the scope of the technical spirit of the present disclosure is not limited by these embodiments. Accordingly, the above-described embodiments should be understood to be exemplary and not limiting in any aspect. The scope of the disclosure should be construed by the appended claims, and all technical concepts within the scopes of their equivalents should be construed as being included in the scope of the disclosure. The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

**Claims**

1. A display panel comprising:

    a substrate (10) including a plurality of pixels (P), each having a first pattern area (IA1) and a second pattern area (IA2) adjacent to the first pattern area (IA1);
    an insulating layer (40) disposed on the substrate (10) and including a first intaglio pattern (IP1) disposed in the first pattern area (IA1); and
    a pair of light-emitting elements (LD1-1, LD1-2) disposed on the first intaglio pattern (IP1) of the insulating layer (40),
    wherein the first intaglio pattern (IP1) has a length in a first direction and a length in a second direction, and respective light-emitting areas (E) of the pair of light-emitting elements (LD1-1, LD1-2) are offset in different directions from an extension line in the first direction or the second direction from a center of the first intaglio pattern (IP1).

2. The display panel of claim 1, further comprising a plane with a longitudinal direction and a width direction, and a cross section in a thickness direction,

    wherein a shortest distance between centers of the pixels (SP1, SP2) adjacent in the longitudinal direction or the width direction of the display panel is set as a first pitch (PP),
    wherein a shortest distance between centers of the pair of light-emitting elements (LD1-1, LD1-2) is set as a first distance (D1), and
    wherein the first distance (D1) is less than or equal to 1/2 of the first pitch (PP).

3. The display panel of claim 2, wherein the pair of light-emitting elements (LD1-1, LD1-2) are arranged in the width direction of the display panel (1), and

    wherein the respective light-emitting areas (E) of the pair of light-emitting elements (LD1-1, LD1-2) are disposed to face each other or the pair of light-emitting elements (LD1-1, LD1-2) are arranged in the longitudinal direction of the display panel (1), and
    wherein the respective light-emitting areas (E) of the pair of light-emitting elements (LD1-1, LD1-2) are disposed in a diagonal direction.

4. The display panel of any one of the preceding claims, further comprising a first adhesive layer (45) disposed between the first intaglio pattern (IP1) of the insulating layer (40) and the pair of light-emitting elements (LD1-1, LD1-2).

5. The display panel of claim 4, wherein the first adhesive layer (47) includes:

    an upper surface in contact with the pair of light-emitting elements (LD1-1, LD1-2);
    a lower surface in contact with the insulating layer (40); and
    a groove (H) adjacent to the pair of light-emitting elements (LD1-1, LD1-2) and defined by a bottom surface between the upper surface and the lower surface and a side surface extending between the upper surface and the bottom surface,
    a first thickness (t1) is formed between the lower surface and the bottom surface, and

    a second thickness (t2) greater than the first thickness (t1) is formed between the upper surface and the lower surface.

6. The display panel of any one of the preceding claims, wherein the insulating layer (40) further includes a second intaglio pattern (IP2) disposed on one side of the first intaglio pattern (IP1) in the second pattern area (IA2).

7. The display panel of claim 6, wherein the first intaglio pattern (IP1) is provided as a plurality of first intaglio patterns, wherein a shortest distance between centers of the plurality of first intaglio patterns (IP1) is set as a second pitch (SPP), wherein a shortest distance between centers of the first intaglio pattern (IP1) and the second intaglio pattern (IP2) is set as a second distance (D2), and the second distance (D2) is less than or equal to 1/2 of the second pitch (SPP).

8. The display panel of claim 6 or 7, further comprising a second adhesive layer (47) on the second intaglio pattern (IP2) of the insulating layer (40).

9. The display panel of claim 8, wherein the second adhesive layer (47) includes: a lower surface in contact with the insulating layer (40); and an upper surface opposite to the lower surface of the second adhesive layer (47), and wherein a third thickness (t3) less than the second thickness (t2) is formed between the lower surface and the upper surface of the second adhesive layer (47).

10. The display panel of any one of the preceding claims, wherein the first intaglio pattern (IP1) includes a 1-1 intaglio pattern, and a 1-2 intaglio pattern,

  wherein the insulating layer (40) further includes a protruding pattern (E) disposed between the 1-1 intaglio pattern and the 1-2 intaglio pattern in the first pattern area (IP1), and
  wherein the pair of light-emitting elements (LD1-1, LD1-2) are disposed in the 1-1 intaglio pattern and the 1-2 intaglio pattern, respectively,
  preferably an area of each of the 1-1 intaglio pattern and the 1-2 intaglio pattern is greater than an area of the second intaglio pattern (IP2).

11. The display panel of any one of claims 6-10, wherein the insulating layer (40) further includes a first dummy intaglio pattern (DP1) disposed in the second pattern area (IA2), the second intaglio pattern (IP2) and the first dummy intaglio pattern (DP1) are disposed on one side of the first intaglio pattern (IP1) to correspond to each pair of light-emitting elements (LD1-1, LD1-2).

12. The display panel of claim 11, wherein the insulating layer (40) further includes a second dummy intaglio pattern (DP2) disposed in the second pattern area (IA2), the second dummy intaglio pattern (DP2) is disposed to surround the first intaglio pattern (IP1), the second intaglio pattern (IP2), and the first dummy intaglio pattern (DP1).

13. A method of manufacturing a display panel, comprising:

  preparing a substrate (10) on which an insulating layer (40) including a first intaglio pattern (IP1) and a second intaglio pattern (IP2) is formed;
  forming a first adhesive layer (45) on the first intaglio pattern (IP1) and forming a second adhesive layer (47) on the second intaglio pattern (IP2), wherein the second adhesive layer (47) has a lower adhesion than the first adhesive layer (45);
  preparing a donor on which a first light-emitting element (LD1-1) and a second light-emitting element (LD1-2) are disposed;
  bonding the donor to the substrate (10) so that the first and second light-emitting elements (LD1-1, LD1-2) are bonded to the first intaglio pattern (IP1); and
  detaching the donor from the substrate (10),
  wherein the first intaglio pattern (IP1) has a length in a first direction and a length in a second direction, and respective light-emitting areas (E) of the first and second light-emitting elements (LD1-1, LD1-2) are offset in different directions from an extension line in the first direction or the second direction from a center of the first intaglio pattern (IP1).

14. The method of claim 13, wherein the bonding the donor to the substrate (10) so that the first and second light-emitting elements (LD1-1, LD1-2) are bonded to the first intaglio pattern (IP1) further includes:

  aligning the donor to the substrate (10) so that the first light-emitting element (LD1-1) corresponds to the first adhesive layer (45) and the second light-emitting element (LD1-2) corresponds to the second adhesive layer (47);
  performing a first stamping of the donor onto the substrate (10),
  detaching the donor from the substrate (10) while the second light-emitting element (LD1-2) remains bonded to the donor;
  rotating the donor 180 degrees while maintaining a state facing the substrate (10);
  performing a second stamping of the 180-degree rotated donor onto the substrate (10) so that the second light-emitting element (LD1-2) is spaced apart from the first light-emitting (LD1-1) element and corresponds to the first adhesive layer (45); and
  detaching the donor from the substrate (10).

15. The method of claim 13 or 14, wherein, in preparing the donor on which the first light-emitting element and the second light-emitting element (LD1-1, LD1-2) are disposed, the respective light-emitting areas (E) of the first light-emitting element and the second light-emitting element (LD1-1, LD1-2) are offset in the same direction from an extension line in a longitudinal direction or a width direction of the donor.

FIG. 1

1

P   NA   AA

Y
Z⊙——→X

FIG. 2   P

SP

SP1   SP2   SP3

LD1-1  LD1-2   LD2-1  LD2-2   LD3-1  LD3-2

IA2

IA1-1   IA1-2   IA1-3

IA1 : IA1-1, IA1-2, IA1-3
LD : LD1-1, LD1-2, LD2-1, LD2-2, LD3-1, LD3-2

FIG. 3

IP1 : IP1-1, IP1-2, IP1-3

FIG. 4

FIG. 5

D2

80
70
51b
60
50
40
30
20
10

H     H

IP1-1   13   94b   91b   45   50   47   IP2

II                                              II'

47   t3   Cb2

Cb1

40

FIG. 6

P

IP1
E2  E1

LD1

SP

LD2
E1
E2

D1

D2

IP2

FIG. 7

P

IP1    D1    D2    IP2

E2
E1

LD1    LD2    E2    E1

SP

FIG. 8

P

IP11

E2  E1

LD1    EP

SP

LD2

E1

E2

D1

D2

IP12    IP2    III    III'

FIG. 9

D1

100a

160  151a  155a  150a 160a 170a  155b  151b  CH

180

170
150
140
30
20
10

H    H  H    H

EP

31 23 11 21 33  IP11 145a  91a 96a 93a  93b 96b 91b  IP12  145b  15

94a 98a    98b 94b

III    LD1-1    LD1-2    13    III'

FIG. 10

P

FIG. 11A

P

FIG. 11B

FIG. 12

A1-a

A2-a

280
270
251b
260
250
240
30
20
10

H        H

IP12   13  94b  91b  245                247  IP2

IV                                                    IV'

FIG. 13

P

IP1

E2  E1

DP1        DP1        DP1

LD1

SP

LD2

IP2        IP2        IP2

E1

E2

FIG. 14

P

IP1

E2  E1

DP1        DP1        DP1        DP1

LD1

SP

LD2

DP1        IP2        IP2        IP2

E2  E1

FIG. 15

P

FIG. 16

P

FIG. 17

Panel

FIG. 18A

Donor

FIG. 18B

Panel

IP1

IP2

E1

E2

LD2  LD1  LD2  LD1  LD2  LD1

Donor

y'
x'

FIG. 18C

Panel

IP1

IP2

E1
E2

LD2  LD2  LD2

Donor

y'
x'

LD1  LD1  LD1

E1
E2

FIG. 18D

Panel

IP1
IP2

E1
E2

LD2    LD2    LD2

Donor

LD1    LD1    LD1

E2
E1

x'
y'

FIG. 18E

Panel

IP1
IP2

E2
E1
LD1
SP
LD2
E1
E2

Donor

x'
y'

FIG. 19A

FIG. 19B

FIG. 19C

FIG. 19D

FIG. 19E

FIG. 19F

Europäisches
Patentamt
European
Patent Office
Office européen
des brevets

# EUROPEAN SEARCH REPORT

Application Number

EP 25 20 8931

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/014195 A1 (BIBL ANDREAS [US] ET AL) 11 January 2024 (2024-01-11) | 1-3,6,7 | INV. H10H29/03 H10H29/34 |
| A | * figures 1A-14 *<br>* paragraph [0044] - paragraph [0090] * | 13-15 | |
| X | US 2021/013186 A1 (CHEN JIA-YUAN [TW] ET AL) 14 January 2021 (2021-01-14) | 1,2,4,6-10 | |
| Y | * figures 1-18 * | 5 | |
| A | * paragraph [0026] - paragraph [0053] * | 3,11,12 | |
| Y | CN 115 116 924 A (HKC CO LTD) 27 September 2022 (2022-09-27) | 5 | |
| A | * figures 12-14 *<br>* paragraph [0101] - paragraph [0105] * | 4,8,9,13-15 | |
| A | GB 2 559 046 A (LG DISPLAY CO LTD [KR]) 25 July 2018 (2018-07-25) * figures 1-7 * * paragraph [0062] - paragraph [0140] * | 1-15 | |

TECHNICAL FIELDS SEARCHED (IPC)

H10H

The present search report has been drawn up for all claims

| Place of search | Date of completion of the search | Examiner |
|---|---|---|
| The Hague | 3 February 2026 | Elattar, Mohamed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 8931

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2026

| Patent document cited in search report | Publication date | Patent family member(s) | Publication date |
|---|---|---|---|
| US 2024014195 A1 | 11-01-2024 | CN 105324858 A | 10-02-2016 |
| | | EP 2997608 A1 | 23-03-2016 |
| | | JP 6159477 B2 | 05-07-2017 |
| | | JP 2016522585 A | 28-07-2016 |
| | | KR 20160010537 A | 27-01-2016 |
| | | KR 20170033905 A | 27-03-2017 |
| | | TW 201515262 A | 16-04-2015 |
| | | TW 201635584 A | 01-10-2016 |
| | | US 2014367705 A1 | 18-12-2014 |
| | | US 2015137153 A1 | 21-05-2015 |
| | | US 2016111405 A1 | 21-04-2016 |
| | | US 2017125392 A1 | 04-05-2017 |
| | | US 2018182746 A1 | 28-06-2018 |
| | | US 2019259739 A1 | 22-08-2019 |
| | | US 2020219863 A1 | 09-07-2020 |
| | | US 2021313305 A1 | 07-10-2021 |
| | | US 2024014195 A1 | 11-01-2024 |
| | | WO 2014204695 A1 | 24-12-2014 |
| US 2021013186 A1 | 14-01-2021 | CN 112216803 A | 12-01-2021 |
| | | CN 120302791 A | 11-07-2025 |
| | | CN 120302792 A | 11-07-2025 |
| | | PH 12020000095 A1 | 18-01-2021 |
| | | US 2021013186 A1 | 14-01-2021 |
| CN 115116924 A | 27-09-2022 | NONE | |
| GB 2559046 A | 25-07-2018 | CN 108206234 A | 26-06-2018 |
| | | DE 102017129926 A1 | 21-06-2018 |
| | | GB 2559046 A | 25-07-2018 |
| | | JP 6639462 B2 | 05-02-2020 |
| | | JP 2018101785 A | 28-06-2018 |
| | | KR 20180071743 A | 28-06-2018 |
| | | KR 20250027256 A | 25-02-2025 |
| | | US RE50146 E | 24-09-2024 |
| | | US 2018175268 A1 | 21-06-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240194284